# EUROPEAN PATENT APPLICATION

(11) **EP 4 539 635 A1**
(43) Date of publication of application: **16.04.2025**
(21) Application number: 24205941.8
(22) Date of filing: 10.10.2024
(51) Int. Cl.: H10D 84/01, H10D 30/47, H10D 30/00, H10D 84/83, H10D 84/85, H10D 88/00

(54) **SEMICONDUCTOR DEVICE, ARRAY STRUCTURE INCLUDING THE SEMICONDUCTOR DEVICE, AND METHOD OF MANUFACTURING THE SEMICONDUCTOR DEVICE**

(30) Priority: 13.10.2023 KR 20230137034; 04.10.2024 KR 20240135096
(71) Applicant: Samsung Electronics Co., Ltd, Suwon-si, Gyeonggi-do 16677 (KR)
(72) Inventor: SEOL, Minsu, 16678 Suwon-si (KR); BYUN, Kyung-Eun, 16678 Suwon-si (KR); KIM, Changhyun, 16678 Suwon-si (KR); LEE, Eunkyu, 16678 Suwon-si (KR)
(74) Representative: Elkington and Fife LLP

(57) **Abstract**

A semiconductor device includes a dielectric wall provided in a direction perpendicular to a substrate, a first metal oxide field effect transistor (MOSFET) provided on one side surface of the dielectric wall, a second MOSFET provided above the first MOSFET in a direction perpendicular to the substrate, and a third MOSFET provided in parallel with the first MOSFET on the other side surface of the dielectric wall.

## Description

### FIELD OF THE INVENTION

The disclosure relates to a semiconductor device, an array structure including the semiconductor device, and a method of manufacturing the semiconductor device.

### BACKGROUND OF THE INVENTION

Transistors are semiconductor devices with an electrical switching function and are employed in various integrated circuit (IC) devices including memory devices, driving ICs, logic devices, etc. In order to increase the degree of integration of IC devices, the space occupied by transistors has been rapidly reduced, and research has been conducted to maintain the performance of IC devices while reducing the size of transistors.

One of the important parts of a transistor is a gate electrode. When a voltage is applied to the gate electrode, a channel adjacent to a gate opens a path for current, and in the opposite case (e.g., when a voltage is not applied to the gate electrode), blocks the path for current. The performance of the channel depends on how much leakage current is reduced and efficiently managed in the gate electrode and channel. The larger the contact area between the gate electrode that controls the current in the transistor and the channel, the greater the power efficiency of the channel and the semiconductor included therein.

As semiconductor processes are becoming more refined, the size of transistors has been decreased, and the area where the gate electrode and the channel contact decreases. Thus, problems due to a short channel effect occur. For example, there are phenomena such as threshold voltage variation, carrier velocity saturation, and deterioration of the subthreshold characteristics. Accordingly, methods of overcoming the short channel effect and effectively reducing a channel length have been sought.

### SUMMARY OF THE INVENTION

Provided is a semiconductor device with reduced area scaling.

Provided is a semiconductor device array structure with reduced area scaling.

Provided is a method of manufacturing a semiconductor device with reduced area scaling.

Additional aspects will be set forth in part in the description which follows and, in part, will be apparent from the description, or may be learned by practice of the presented embodiments of the disclosure.

According to an aspect of the disclosure, a semiconductor device includes a dielectric wall provided in a direction perpendicular to a substrate, a first metal oxide field effect transistor (MOSFET) on a first side surface of the dielectric wall, a second MOSFET above the first MOSFET in a direction perpendicular to the substrate, and a third MOSFET provided in parallel with the first MOSFET on a second side surface of the dielectric wall, the second side surface opposite to the first side surface, wherein the first MOSFET, the second MOSFET, and the third MOSFET are each in direct contact with the dielectric wall.

The first MOSFET may be an n-type or p-type MOSFET, and the second MOSFET may be a type different from the first MOSFET.

The first MOSFET and the second MOSFET may share a gate electrode.

The first MOSFET, the second MOSFET, and the third MOSFET may each include one or more channel sheets, a gate insulating layer on each of the one or more channel sheets, and a gate electrode on the gate insulating layer, and one side surface of each of the one or more channel sheets may be in direct contact with the dielectric wall.

The one or more channel sheets may include a two-dimensional (2D) semiconductor material.

The 2D semiconductor material may include at least one of graphene, black phosphorus, phosphorene, or transition metal dichalcogenide (TMD).

The semiconductor device may further include a fourth MOSFET provided above the third MOSFET in the direction perpendicular to the substrate.

The semiconductor device may further include an isolator between the first MOSFET and the second MOSFET.

The dielectric wall may include at least one of a metal oxide, metal nitride, metal oxynitride, or boron nitride.

The dielectric wall may include at least one of silicon nitride (SiNₓ), silicon oxynitride (SiOₓN_{y}), amorphous boron nitride (a-BN), or boron carbon nitride (BCN).

According to another aspect of at least one embodiment, a semiconductor device array structure including one or more rows in which a plurality of semiconductor devices are arranged in a direction perpendicular to a substrate, wherein each of the plurality of semiconductor devices includes a dielectric wall provided in the direction perpendicular to a substrate, a first MOSFET on a first side surface of the dielectric wall, a second MOSFET above the first MOSFET in the direction perpendicular to the substrate, and a third MOSFET provided in parallel with the first MOSFET on a second side surface of the dielectric wall, the second side surface opposite to the first side surface, the first MOSFET, the second MOSFET, and the third MOSFET are in direct contact with the dielectric wall, and the dielectric wall commonly and continuously extends along each of the one or more rows.

The one or more rows may include a first row in which the plurality of semiconductor devices are arranged in a line in a first direction; and a second row in which the plurality of semiconductor devices are arranged in parallel with the first direction and at the same height.

The semiconductor device array structure may further include a second dielectric wall between the first row and the second row, wherein the first row and the second row are in contact with the second dielectric wall.

The one or more rows a first row in which the plurality of semiconductor devices are arranged in a line in a first direction, and a second row in which the plurality of semiconductor devices are arranged in parallel with the first direction and alternate at different heights.

According to another aspect of at least one embodiment, a method of manufacturing a semiconductor device includes alternately stacking first sacrificial layers and first channel sheets on a substrate, alternately stacking second sacrificial layers and second channel sheets on the first sacrificial layers, forming a first source electrode and a first drain electrode such that the first source electrode and the first drain electrode are connected to the first channel sheets, forming a second source electrode and a second drain electrode such that the second source electrode and the second drain electrode are connected to the second channel sheet, removing the first and second sacrificial layers, forming gate insulating layers such that a gate insulating layer is on each of the first channel sheets and the second channel sheets, forming a first gate electrode and a second gate electrode around the gate insulating layer, forming a trench by etching from an upper surface of the second gate electrode to the substrate, and forming a dielectric wall by depositing a dielectric in the trench.

The first channel sheets may be an n-type or p-type channel, and each of the second channel sheets may be a different type of channel from the first channel sheets.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a perspective view of a semiconductor device according to at least one embodiment;
FIG. 2 is a perspective view of a semiconductor device excluding the electrodes;
FIG. 3 is a cross-sectional view taken along line A-A' of the semiconductor device of FIG. 1;
FIG. 4 is a cross-sectional view taken along line B-B' of the semiconductor device of FIG. 1;
FIG. 5A shows an example of a cross-sectional view taken along line B-B' of the semiconductor device of FIG. 1 in which a voltage supply structure is changed compared to FIG. 4 is changed;
FIG. 5B is a cross-sectional view taken along line C-C' of FIG. 5A;
FIG. 6 shows an example in which an isolator is further provided in FIG. 3;
FIG. 7 shows a voltage application structure of FIG. 6;
FIG. 8 is a perspective view of a semiconductor device according to at least one embodiment;
FIG. 9 is a cross-sectional view taken along line D-D' of the semiconductor device of FIG. 8;
FIGS. 10 to 12 schematically illustrate a semiconductor device array structure according to at least one embodiment;
FIGS. 13A to 18B illustrate a method of manufacturing a semiconductor device according to at least one embodiment;
FIGS. 19A to 22B illustrate a method of manufacturing a semiconductor device according to at least one embodiment;
FIG. 23 is a schematic block diagram of a display driver integrated circuit (DDI) including a field effect transistor (FET) and a display device including the DDI, according to at least one embodiment;
FIG. 24 is a circuit diagram of an inverter including a semiconductor device according to at least one embodiment;
FIG. 25 is a circuit diagram of an SRAM device including a semiconductor device according to at least one embodiment;
FIG. 26 is a circuit diagram of a NAND circuit including a semiconductor device according to at least one embodiment;
FIG. 27 is a block diagram of an electronic system including a semiconductor device according to at least one embodiment; and
FIG. 28 is a block diagram of an electronic system including a semiconductor device according to at least one embodiment.

### DETAILED DESCRIPTION

Reference will now be made in detail to some embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. Further, when the terms "about" or "substantially" are used in this specification in connection with a numerical value and/or geometric terms, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical values and/or geometry.

Hereinafter, a semiconductor device, an array structure having the semiconductor device and a method of manufacturing the semiconductor device according to some embodiments are described in detail with reference to the attached drawings. In the drawings, like reference numerals in the drawings denote like elements, and sizes of components in the drawings may be exaggerated for clarity and convenience of explanation. While such terms as "first," "second," etc., may be used to describe various components, such components must not be limited to the above terms. The above terms are used only to distinguish one component from another.

An expression used in the singular encompasses the expression of the plural, unless it has a clearly different meaning in the context. When a portion "includes" a component, another component may be further included, rather than excluding the existence of the other component, unless otherwise described. Sizes or thicknesses of components in the drawings may be arbitrarily exaggerated for convenience of explanation. It will also be understood that spatially relative terms, such as "above", "top", etc., are intended to encompass different orientations of the device in use or operation in addition to the orientation depicted in the figures, and that the device may be otherwise oriented (rotated 90 degrees or at other orientations) and the spatially relative terms used herein interpreted accordingly. Further, when a certain material layer is described as being arranged on a substrate or another layer, the material layer may be in contact with the other layer, or there may be a third layer between the material layer and the other layer. In the following embodiment, materials constituting each layer are provided merely as an example, and other materials may also be used.

Moreover, the terms "part," "module," etc. refer to a unit processing at least one function or operation, and may be implemented by processing circuitry, such as a hardware, a software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

The particular implementations shown and described herein are illustrative examples of embodiments and are not intended to otherwise limit the scope of embodiments in any way. For the sake of brevity, conventional electronics, control systems, software development and other functional aspects of the systems may not be described in detail. Furthermore, the connecting lines, or connectors shown in the various figures presented are intended to represent functional relationships and/or physical or logical couplings between the various elements. It should be noted that many alternative or additional functional relationships, physical connections or logical connections may be present in a practical device.

The use of the terms "a" and "an" and "the" and similar referents are to be construed to cover both the singular and the plural.

Also, operations of all methods described herein may be performed in any suitable order unless otherwise indicated herein or otherwise clearly contradicted by context. The use of any and all exemplary languages (e.g., "such as") provided herein, are intended merely to better illuminate the technical ideas and does not pose a limitation on the scope of rights unless otherwise claimed.

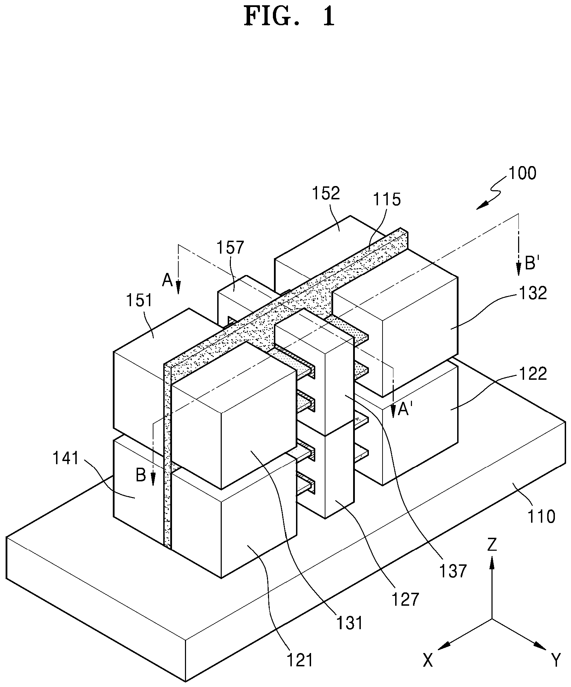

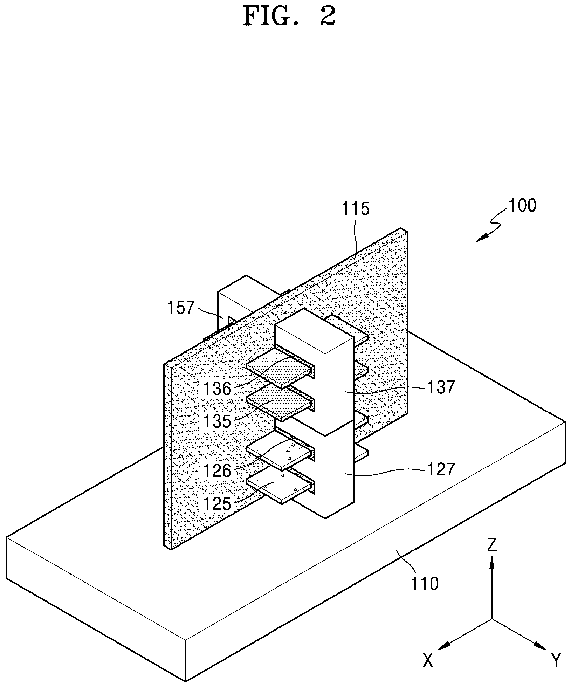

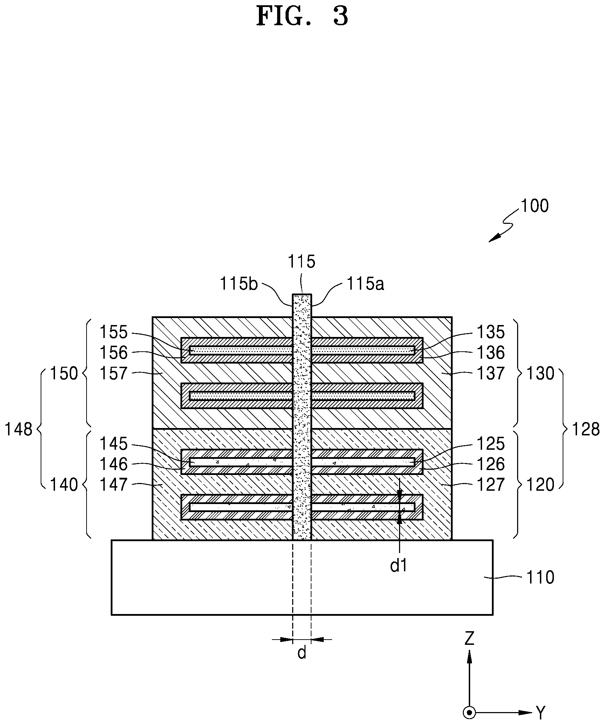

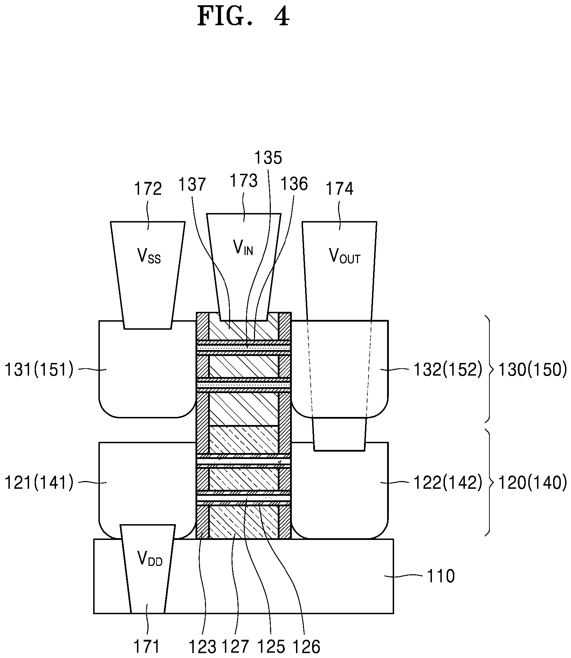

FIG. 1 is a perspective view of a semiconductor device according to at least one embodiment. FIG. 2 is a perspective view of a semiconductor device excluding an electrode. FIG. 3 is a cross-sectional view taken along line A-A' of the semiconductor device of FIG. 1. FIG. 4 is a cross-sectional view taken along line B-B' of the semiconductor device of FIG. 1.

A semiconductor device 100 may include a dielectric wall 115 provided in a direction (Z direction) perpendicular to a substrate 110, a first metal oxide semiconductor field effect transistor (hereinafter referred to as MOSFET) 120 provided on the substrate 110 in contact with one side surface of the dielectric wall 115, a second MOSFET 130 provided above the first MOSFET 120 in the direction (Z direction) perpendicular to a substrate 110, a third MOSFET 140 provided on the substrate 110 in contact with the other side surface of the dielectric wall 115, and a fourth MOSFET 150 provided on the third MOSFET 140. The second MOSFET 130 and the fourth MOSFET 150 may also be disposed in direct contact with the dielectric wall 115.

The substrate 110 may be an insulating substrate and/or a semiconductor substrate with an insulating layer formed on its surface. In at least one embodiment, the substrate 110 may include, for example, a group IV semiconductor (such as silicon (Si), (e.g., single crystal silicon, polycrystalline silicon, and/or amorphous silicon), and/or germanium (Ge)), a group IV-IV compound semiconductor (such as silicon germanium (SiGe) and/or silicon carbide (SiC)), and/or a group III-V compound semiconductor (such as gallium arsenide (GaAs), indium arsenide (InAs), indium, and/or phosphide (InP)), etc. The substrate 110 may be based on a silicon (Si) bulk substrate and/or a silicon on insulator (SOI) substrate. The substrate 110 is not limited to the bulk or SOI substrate, and may be a substrate based on an epitaxial wafer, a polished wafer, or an annealed wafer.

The substrate 110 may include a conductive region, for example, a well doped with impurities, and/or various structures doped with impurities. In addition, the substrate 110 may be configured as a p-type substrate or an n-type substrate depending on the type of impurity ion to be doped.

The dielectric wall 115 may include an insulator material, such as at least one of a metal oxide, a metal nitride, a metal oxynitride, and/or a boron nitride. The dielectric wall 115 may include, for example, silicon nitride (SiNₓ), silicon oxynitride (SiOₓN_{y}), amorphous boron nitride (a-BN), and/or boron carbon nitride (BCN), wherein x and y respectively represent real numbers greater than one (1). However, the dielectric wall 115 is not limited thereto and may include various dielectric materials. For example, the dielectric wall 115 may include SiO₂ and/or carbon doped silicon oxide. The dielectric wall 115 may be in the form of a very thin plate. The dielectric wall 115 may include a first surface 115a and a second surface 115b opposite the first surface 115a. The first MOSFET 120 and the second MOSFET 130 may be disposed in the first surface 115a in contact with each other, and the third MOSFET 140 and the fourth MOSFET 150 may be disposed in the second surface 115b in contact with each other. The dielectric wall 115 may have a thickness d in the range of about 2 nm to about 50 nm and/or a thickness d in the range of about 3 nm to about 20 nm.

The first MOSFET 120 and the second MOSFET 130 may configure a first complementary field effect transistor (CFET) 128. CFET may represent a structure in which transistors of different conductivity types are vertically stacked. In addition, the CFET may include a nanosheet-type channel. The first MOSFET 120 may be an n-type or p-type MOSFET, and the second MOSFET 130 may be a MOSFET having a different type of conductivity from the first MOSFET 120. For example, when the first MOSFET 120 has an n-type MOSFET, the second MOSFET 130 may be a p-type MOSFET. Alternatively, when the first MOSFET 120 has a p-type MOSFET, the second MOSFET 130 may be an n-type MOSFET.

The third MOSFET 140 may be provided in parallel with the first MOSFET 120 with the dielectric wall 115 disposed therebetween. For example, the third channel sheet 145 of the third MOSFET 140 may be provided in parallel with the first channel sheet 125 of the first MOSFET 120 with the dielectric wall 115 disposed therebetween. The third MOSFET 140 may be a p-type or n-type MOSFET.

The fourth MOSFET 150 may be provided above the third MOSFET 140 in the direction (Z direction) perpendicular to the substrate 110. The fourth MOSFET 150 may have a different type of conductivity from the third MOSFET 140. The third MOSFET 140 and the fourth MOSFET 150 may configure a second CFET 148. A distance between the first CFET 128 and the second CFET 148 may be defined by the thickness d of the dielectric wall 115. By thinning the thickness d of the dielectric wall 115, scaling of the semiconductor device 100 may be reduced.

The first MOSFET 120 may include one or more first channel sheets 125 arranged in parallel and spaced apart in the direction (Z direction) perpendicular to the substrate 110, a first gate insulating layer 126 surrounding the one or more first channel sheets 125, and a first gate electrode 127 surrounding the first gate insulating layer 126. The first channel sheet 125 may include a two-dimensional (2D) semiconductor material.

The 2D semiconductor material refers to a semiconductor material that has a 2D crystal structure and may have a monolayer and/or multilayer structure. Each layer constituting the 2D semiconductor material may have a thickness of an atomic level.

In the semiconductor device 100, the first channel sheet 125 may include the 2D semiconductor material to implement a shorter channel length. Here, the channel length may represent a channel length between a first source electrode 121 and a first drain electrode 122. The channel length is related to a thickness d1 of the first channel sheet 125, and the channel length may be set to a minimum length determined by the thickness d1 of the first channel sheet 125. As the thickness d1 of the first channel sheet 125 becomes thinner, the channel length may be reduced, and the size of a FET may be reduced.

In at least one embodiment, the thickness d1 of the first channel sheet 125 may be 20 nm or less, 5 nm or less and/or 1 nm or less. The 2D semiconductor material may have excellent electrical characteristics, and maintain high mobility even when its thickness is reduced to nano scale, and thus may be applied to various devices.

The 2D semiconductor material may include, for example, at least one of graphene, black phosphorous, phosphorene, transition metal dichalcogenide (TMD), and the like. Graphene, which is a material that has a hexagonal honeycomb structure in which carbon atoms are 2D bonded, has the advantages of high electrical mobility, excellent thermal properties, high chemical stability, and a large surface area compared to silicon (Si). Graphene may be doped to be semiconductive. Also, black phosphorus is a material in which black phosphorous atoms are 2D bonded.

TMD may be expressed, for example, as MX₂, where M represents a transition metal and X represents a chalcogen element. For example, M may be Mo, W, Nb, V, Ta, Ti, Zr, Hf, Tc, Re, etc., and X may be S, Se, Te, etc. Thus, for example, the TMD may include MoS₂, MoSe₂, MoTe₂, WS₂, WSe₂, WTe₂, ZrS₂, ZrSe₂, HfS₂, HfSe₂, NbSe₂, and/or ReSe₂. Alternatively, the TMD may not be expressed as MX₂. In these cases, for example, the TMD may include CuS, which is a compound of Cu, a transition metal, and S, a chalcogen element. Meanwhile, The MD may be a chalcogenide material including a non-transition metal. The non-transition metal may include, for example, Ga, In, Sn, Ge, Pb, etc. In this case, the TMD may include a compound of non-transition metal such as Ga, In, Sn, Ge, and Pb and a chalcogen element such as S, Se, and Te. For example, the TMD may include SnSe₂, GaS, GaSe, GaTe, GeSe, In₂Se₃, InSnS₂, etc.

As described above, the TMD may include one metal element among Mo, W, Nb, V, Ta, Ti, Zr, Hf, Tc, Re, Cu, Ga, In, Sn, Ge, Pb and one chalcogen element among S, Se, and Te. However, the materials mentioned above are merely examples, and other materials may be used as the TMD material.

The 2D semiconductor material may be doped with p-type dopant and/or n-type dopant to control mobility. Here, the p-type dopant and n-type dopant may be, for example, p-type dopant and n-type dopant used in graphene or carbon nanotube (CNT). The p-type dopant or n-type dopant may be doped by using ion implantation and/or chemical doping.

One side surface of each of the one or more first channel sheets 125 may be in contact with the dielectric wall 115. The one or more first channel sheets 125 may include a sheet structure having a nano-thickness in the direction (Z direction) perpendicular to the substrate 110, and a plane of the first channel sheet 125 may be arranged parallel to the substrate 110. Here, the thickness d1 of the first channel sheet 125 may represent a thickness in the thinnest direction (Z direction). The plane of the first channel sheet 125 may have a long rectangular shape when viewed in a plan view. For example, the first channel sheet 125 may have a rectangular shape in which a length in a first direction (X direction) is longer than a length in a second direction (Y direction). However, the shape of the first channel sheet 125 is not limited thereto. A plurality of first channel sheets 125 may be arranged to be spaced apart from each other along the dielectric wall 115 in the direction (Z direction) perpendicular to the substrate 110. The first channel sheets 125 may be disposed such that a side surface in the first direction (long direction and X direction) among side surfaces including the thickness d1 of the first channel sheet 125 may be in contact with the dielectric wall 115. The one or more first channel sheets 125 may include 1 to 10 layers. The one or more first channel sheets 125 may include 1 to 5 layers.

The first gate insulating layer 126 may be provided to surround three side surfaces of the first channel sheets 125, and one side surface of the first gate insulating layer 126 may be in contact with the dielectric wall 115. The first gate insulating layer 126 may have a shape surrounding the first channel sheet 125 in a path with one side surface open. The first gate insulating layer 126 may insulate between the first channel sheet 125 and the gate electrode 127 and may suppress leakage current. The first gate insulating layer 126 may include at least one of low-doped silicon, SiO₂, Al₂O₃, HfO₂, Si₃N₄, etc. However, the first gate insulating layer 126 is not limited thereto and may include various types of insulating materials.

The first gate electrode 127 may be provided to surround the first channel sheet 125 and the first gate insulating layer 126. Also, the first gate electrode 127 may be completely filled in spaces between the neighboring first channel sheets 125.

The second MOSFET 130 may be provided on an upper portion of the first MOSFET 120. The second MOSFET 130 may include one or more second channel sheets 135 arranged in parallel and spaced apart in the direction (Z direction) perpendicular to the substrate 110, a second gate insulating layer 136 surrounding the one or more second channel sheets 135, and a second gate electrode 137 surrounding the second gate insulating layer 136. The second channel sheet 135 may include a 2D semiconductor material. The 2D semiconductor material is the same as and/or substantially similar to the 2D semiconductor material described above. The second channel sheet 135 may include a dopant of a conductivity type opposite to that of the first channel sheet 125. A material of each of the second gate insulating layer 136 and the second gate electrode 137 may be the same as and/or different from a material of each of the first gate insulating layer 126 and the first gate electrode 127 within the range described with respect to the material of each of the first gate insulating layer 126 and the first gate electrode 127.

One side surface of each of the one or more second channel sheets 135 may be in contact with the dielectric wall 115. The one or more second channel sheets 135 may include a sheet structure having the nano-thickness (Z direction), and a plane of the second channel sheet 135 may be arranged parallel to the substrate 110. The plane of the second channel sheet 135 may have a long rectangular shape when viewed in a plan view. For example, the second channel sheet 135 may have a rectangular shape in which the length in the first direction (X direction) is longer than the length in the second direction (Y direction). A plurality of second channel sheets 135 may be arranged to be spaced apart from each other along the dielectric wall 115 in the direction (Z direction) perpendicular to the substrate 110. The second channel sheets 135 may be disposed such that a side surface in the first direction (long direction) among side surfaces including a thickness of the second channel sheet 135 may be in contact with the dielectric wall 115.

The second gate insulating layer 136 may be provided to surround three side surfaces of the second channel sheet 135, and one side surface of the second gate insulating layer 136 may be in contact with the dielectric wall 115. The second gate insulating layer 136 may have a shape surrounding the second channel sheet 135 in a path with one side surface open. The second gate electrode 137 may be provided to surround the second channel sheet 135 and the second gate insulating layer 136.

The second channel sheet 135 may be doped with dopant of a different conductivity type from the first channel sheet 125. When the first channel sheet 125 is doped with an n-type dopant, the second channel sheet 135 may be doped with a p-type dopant. FIG. 1 shows that the first gate electrode 127 and the second gate electrode 137 are configured as different bodies, but the first gate electrode 127 and the second gate electrode 137 may be configured as the same body. In other words, the first gate electrode 127 and the second gate electrode 137 may be commonly configured such that the first MOSFET 120 and the second MOSFET 130 share the gate electrode. The first MOSFET 120 and the second MOSFET 130 may configure an inverter circuit. The inverter circuit may be provided in the same direction with respect to the dielectric wall 115.

The third MOSFET 140 may be an n-type or p-type MOSFET, and the fourth MOSFET 150 may be a different type of MOSFET from the third MOSFET 140. For example, when the third MOSFET 140 is an n-type MOSFET, the fourth MOSFET 150 may be a p-type MOSFET. Alternatively, when the third MOSFET 140 is a p-type MOSFET, the fourth MOSFET 150 may be an n-type MOSFET.

The third MOSFET 140 may include one or more third channel sheets 145 arranged in parallel and spaced apart in the direction (Z direction) perpendicular to the substrate 110, a third gate insulating layer 146 surrounding the one or more third channel sheets 145, and a third gate electrode 147 surrounding the third gate insulating layer 146. The third channel sheet 145 may include a 2D semiconductor material. The 2D semiconductor material may be the same as and/or substantially similar to the 2D semiconductor material described above, and the third channel sheet 145 may include the same 2D semiconductor material as that of the second channel sheet 135. Alternatively, the third channel sheet 145 may include a 2D semiconductor material different from that of the second channel sheet 135.

One side surface of each of the one or more third channel sheets 145 may be in contact with the dielectric wall 115. The one or more third channel sheets 145 may include a sheet structure having the nano-thickness (Z direction), and a plane of the third channel sheet 145 may be arranged parallel to the substrate 110. Here, a thickness of the third channel sheet 145 may represent a thickness in the thinnest direction (Z direction). The plane of the third channel sheet 145 may have a long rectangular shape when viewed in a plan view. For example, the third channel sheet 145 may have a rectangular shape in which the length in the first direction (X direction) is longer than the length in the second direction (Y direction). A plurality of third channel sheets 145 may be arranged to be spaced apart from each other along the dielectric wall 115 in the direction (Z direction) perpendicular to the substrate 110. The third channel sheets 145 may be arranged disposed such that a side surface in the first direction (long direction) among side surfaces including the thickness of the third channel sheet 145 may be in contact with the dielectric wall 115.

The third gate insulating layer 146 may be provided to surround three side surfaces of the third channel sheet 145, and one side surface of the third gate insulating layer 146 may be in contact with the dielectric wall 115. The third gate insulating layer 146 may have a shape surrounding the third channel sheet 145 in a path with one side surface open. The third gate electrode 147 may be provided to surround the third channel sheet 145 and the third gate insulating layer 146.

The fourth MOSFET 150 may include one or more fourth channel sheets 155 arranged in parallel and spaced apart in the direction (Z direction) perpendicular to the substrate 110, a fourth gate insulating layer 156 surrounding the one or more fourth channel sheets 155, and a fourth gate electrode 157 surrounding the fourth gate insulating layer 156. The fourth channel sheet 155 may include a 2D semiconductor material. The fourth channel sheet 155 may include a dopant of a conductivity type opposite to that of the third channel sheet 145.

One side surface of each of the one or more fourth channel sheets 155 may be in contact with the dielectric wall 115. The one or more fourth channel sheets 155 may include a sheet structure having the nano-thickness (Z direction), and a plane of the fourth channel sheet 155 may be arranged parallel to the substrate 110. The plane of the fourth channel sheet 155 may have a long rectangular shape when viewed in a plan view. For example, the fourth channel sheet 155 may have a rectangular shape in which the length in the first direction (X direction) is longer than the length in the second direction (Y direction). A plurality of fourth channel sheets 155 may be arranged to be spaced apart from each other along the dielectric wall 115 in the direction (Z direction) perpendicular to the substrate 110. The fourth channel sheets 155 may be disposed such that a side surface in the first direction (long direction) among side surfaces including a thickness of the fourth channel sheet 155 may be in contact with the dielectric wall 115.

The fourth gate insulating layer 156 may be provided to surround three side surfaces of the fourth channel sheet 155, and one side surface of the fourth gate insulating layer 156 may be in contact with the dielectric wall 115. The fourth gate insulating layer 156 may have a shape surrounding the fourth channel sheet 155 in a path with one side surface open. The fourth gate electrode 157 may be provided to surround the fourth channel sheet 155 and the fourth gate insulating layer 156.

The fourth channel sheet 155 may be doped with a dopant of a different conductivity type from the third channel sheet 145. For example, when the third channel sheet 157 is doped with an n-type dopant, the fourth channel sheet 155 may be doped with a p-type dopant. FIG. 3 shows that the third gate electrode 147 and the fourth gate electrode 157 are configured as different bodies, but the third gate electrode 147 and the fourth gate electrode 157 may be configured as the same body. In other words, the third gate electrode 147 and the fourth gate electrode 157 may be commonly configured such that the third MOSFET 140 and the fourth MOSFET 150 share the gate electrode. The third MOSFET 140 and the fourth MOSFET 150 may configure an inverter circuit. The inverter circuit may be provided in the same direction with respect to the dielectric wall 115.

FIG. 4 is a cross-sectional view taken along line B-B' of the semiconductor device of FIG. 1.

The first source electrode 121 may be provided on one side of the first channel sheet 125, and the first drain electrode 122 may be provided on the other side thereof. The first channel sheet 125 may be connected between the first source electrode 121 and the first drain electrode 122 to become a passage through which current flows between the first source electrode 121 and the first drain electrode 122. The first channel sheet 125 may be in direct contact with the first source electrode 121 and the first drain electrode 122. However, the first channel sheet 125 is not limited thereto, and the first channel sheet 125 may be connected to the first source electrode 121 and the first drain electrode 122 through another medium. The first source electrode 121 and the second drain electrode 122 may be in direct contact with the dielectric wall 115. However, the first source electrode 121 and the second drain electrode 122 are not limited thereto, and may be disposed spaced apart from the dielectric wall 115.

A second source electrode 131 may be provided on one side of the second channel sheet 135, and a second drain electrode 132 may be provided on the other side thereof. The first source electrode 121 and the second source electrode 131 may be arranged spaced apart from each other, and the first drain electrode 122 and the second drain electrode 132 may be arranged spaced apart from each other. Meanwhile, in at least some embodiments, an insulating layer 123 may be respectively provided at both ends between the first channel sheets 125 and at both ends between the second channel sheets 135. That is, the insulating layer 123 may be respectively provided between the first gate electrode 127 and the first source electrode 121, between the first gate electrode 127 and the first drain electrode 122, between the second gate electrode 137 and the second source electrode 131, and between the second gate electrode 137 and the second drain electrode 132. The insulating layer 123 may also serve as a spacer that supports the first channel sheet (125) and the second channel sheet (135) along with the function of insulation.

A third source electrode 141 and a third drain electrode 142 included in the third MOSFET 140 are similar to the first source electrode 121 and first drain electrode 122 described above, and the fourth source electrode 151 and the fourth drain electrode 152 included in the fourth MOSFET 150 are similar to the second source electrode 131 and the second drain electrode 13 described above, and thus, detailed descriptions thereof are omitted here.

Meanwhile, the thickness of each of the first channel sheet 125, the second channel sheet 135, the third channel sheet 145, and the fourth channel sheet 155 may be 20 nm or less, 10 nm or less, and/or 5 nm or less. A distance between the first source electrode 121 and the first drain electrode 122 may be, for example, 100 nm or less, 50 nm or less, and/or 20 nm or less. A distance range between the first source electrode 121 and the first drain electrode 122 may also be applied to the distance between the second source electrode 131 and the second drain electrode 132, the distance between the third source electrode 141 and the third drain electrode 142, and the distance between the fourth source electrode 151 and the fourth drain electrode 152.

As shown in FIG. 4, the first gate insulating layer 126 may be provided in contact with upper and lower portions of the first channel sheet 125, and the second gate insulating layer 136 may be provided in contact with upper and lower portions of the second channel sheet 135. In addition, the first gate electrode 127 may be provided between the first gate insulating layers 126, and the second gate electrode 137 may be provided between the second gate insulating layers 136. The first gate insulating layer 126 may insulate between the first channel sheet 125 and the first gate electrode 127, and the second gate insulating layer 136 may insulate between the second channel sheet 135 and the second gate electrode 137.

The semiconductor device 100 may be referred to as having a multi-bridge structure in which the first channel sheet 125 and the second channel sheet 135 are respectively stacked spaced in a direction away from the substrate 110 between the first source electrode 121 and the first drain electrode 122 and between the second source electrode 131 and the second drain electrode 132. A channel with a multi-bridge structure may reduce short channel effects and reduce an area occupied by source/drain electrodes, and thus, the channel is advantageous for high integration. In addition, the channel may maintain uniform source/drain junction capacitance regardless of a position of the channel, and thus, the channel may be applied as a high-speed and high-reliability device. FIG. 4 shows the multi-bridge channel including two channel sheets, but this is an example and is not limited thereto, and the number of each of the first to fourth channel sheets 125, 135, 145, and 155 may be, for example, 1 to 10. Alternatively, the number of each of the first to fourth channel sheets 125, 135, 145, and 155 may be, for example, 1-5.

Next, a voltage application structure of the semiconductor device 100 is described. The first source electrode 121 of the first MOSFET 120 may be connected to the first contact 171 extending from a lower portion of the substrate 110, and the second source electrode 131 of the second MOSFET 130 may be connected to the second contact 172 extending from an upper portion of the second MOSFET 130. Alternatively, positions of the second source electrode 131 and the second drain electrode 132 of the second MOSFET 130 may be switched. In this case, the first source electrode 121 of the first MOSFET 120 may be connected to a first contact 171, and the second drain electrode 132 of the second MOSFET 130 may be connected to a second contact 172. The first contact 171 and the second contact 172 may each be connected to a power input line. A power supply voltage V_{DD} may be applied through the first contact 171, and a ground voltage Vss may be applied through the second contact 172. An input contact 173 may be connected to the second gate 135, and an output contact 174 may be connected to each of the first drain electrode 122 and the second drain electrode 132. Alternatively, when the positions of the second source electrode 131 and the second drain electrode 132 of the second MOSFET 130 are switched, the out contact 174 may be connected to the second source electrode 131. The input contact 173 and the output contact 174 may be connected from an upper portion of the second MOSFET 130. An input voltage V_{IN} may be applied through the input contact 173, and an output voltage V_{OUT} may be output through the output contact 174.

The first to fourth source electrodes 121, 131, 141, and 151 and the first to fourth drain electrodes 122, 132, 142, and 152 may each include a material having electrical conductivity such as a metal, a conductive nitride, and/or a conductive oxide. For example, the first to fourth source electrodes 121, 131, 141, and 151 and the first to fourth drain electrodes 122, 132, 142, and 152 may each include at least one of magnesium (Mg), aluminum (Al), scandium (Sc), titanium (Ti), vanadium (V), chromium (Cr), manganese (Mn), nickel (Ni), copper (Cu), zinc (Zn), gallium (Ga), zirconium (Zr), niobium (Nb), molybdenum (Mo), lead (Pd), silver (Ag), cadmium (Cd), indium (In), tin (Sn), lanthanum (La), hafnium (Hf), tantalum (Ta), tungsten (W), iridium (Ir), platinum (Pt), gold (Au), palladium (Pd), ruthenium (Ru), antimony (Sb), bismuth (Bi), and/or a combination thereof.

For example, the first MOS FET 120 may include at least one n-type channel sheet, and a source electrode and a drain electrode connected to the at least one n-type channel sheet, wherein the at least one n-type channel sheet includes an n-type MoS₂ channel sheet, and the source electrode and the drain electrode may include at least one of Au, Ni, TiN, Sb, Bi, Ag, Sn, and Ti. For example, the second MOS FET 130 may include at least one p-type channel sheet, and a source electrode and a drain electrode connected to the at least one p-type channel sheet, wherein the at least one p-type channel sheet includes a p-type WSe₂ channel sheet, and the source electrode and the drain electrode may include at least one of Pd, Pt, TiN, and Ru.

The first to fourth gate electrodes 127, 137, 147, and 157 may each include a material having conductivity such as a metal, a conductive nitride, or a conductive oxide. Here, the metal material may include, for example, at least one of Ag, Au, Ti, TiN, TaN, W, Mo, WN, Pt, and/or Ni, or a combination thereof. The conductive oxide may include, for example, Indium Tin Oxide (ITO), Indium Zinc Oxide (IZO), etc. Alternatively, the first to fourth gate electrodes 127, 137, 147, and 157 may respectively include the same materials as those of the first to fourth source electrodes 121, 131, 141, and 151 and the first to fourth drain electrodes 122, 132, 142, and 152.

The first to fourth gate insulating layers 126, 136, 146, and 156 may each include a high-k dielectric material, which is a material with a dielectric constant higher than silicon oxide. The first to fourth gate insulating layers 126, 136, 146, and 156 may each include, for example, aluminum oxide, hafnium oxide, zirconium hafnium oxide, lanthanum oxide, and/or the like. However, the first to fourth gate insulating layers 126, 136, 146, and 156 are not limited thereto.

In at least one embodiment, the first to fourth gate insulating layers 126, 136, 146, and 156 may each include a ferroelectric material. Ferroelectric materials have a spontaneous electric dipole due to non-centrosymmetric charge distribution within a unit cell in a crystallized material structure, that results in spontaneous polarization. Therefore, the ferroelectric material has remnant polarization due to a dipole even in the absence of an external electric field. In addition, a direction of polarization may be switched in a domain unit by the external electric field. Such a ferroelectric material may include, for example, an oxide including at least one selected from Hf, Si, Al, Zr, Y, La, Gd, and Sr, with a non-centrosymmetric crystalline phase, but this is an example. In addition, in at least some embodiments, the ferroelectric material may further include a dopant, e.g., to enhance the ferroelectric properties and/or to induce the non-centrosymmetric crystalline phase.

When the first to fourth gate insulating layers 126, 136, 146, and 156 each includes the ferroelectric material, a subthreshold swing (SS) may be lowered due to a negative capacitance effect, and thus, performance may be improved while reducing the size of the semiconductor device 100.

The semiconductor device 100 may be applied to, for example, a logic device or a memory device. The logic device is responsible for calculation and control, and the memory device is responsible for storing information. The logic device may be applied to a micro component, an analog IC, a logic IC, etc. The analog IC may include a power semiconductor, an image sensor, a touch controller, etc. The logic IC may include a display driver IC (DDI), T-CON, a media IC, an application processor (AP), and an automotive semiconductor. The memory device may include dynamic random access memory (DRAM), static RAM (SRAM), NAND memory, etc.

The semiconductor device 100 according to the embodiment uses a 2D semiconductor material as a channel material, thereby reducing the short channel effect and implementing a short channel length. The short channel effect means the performance limit that appears when the channel length is shortened, and are, for example, a phenomenon such as threshold voltage variation, carrier velocity saturation, and deterioration of sub-threshold characteristics.

The short channel effect is known to be related to a channel thickness. As the channel thickness becomes thinner, the minimum channel length that may be implemented becomes shorter. Therefore, when an ultra-small transistor is to be implemented to increase integration, the channel length may be effectively reduced by reducing the channel thickness.

On the other hand, in the case where the channel thickness is reduced with a typical bulk material, for example, a silicon-based material, when the thickness is reduced to several nanometers or less, the number of carriers inside the silicon decreases, which causes a problem of lowering electron mobility. In the semiconductor device 100 of the embodiment, the channel sheet includes the 2D semiconductor material, and thus, high electron mobility may be maintained even though the thickness of the channel sheet is reduced to several nanometers or less. Therefore, in the semiconductor device 100 of the embodiment, the minimum channel length due to the short channel effect may be shortened, and excellent performance may be achieved.

In addition, the semiconductor device 100 according to at least one embodiment may have a structure in which a gate electrode surrounds three sides of the channel sheet, more precisely control current, mitigate leakage, and achieve high power efficiency. The semiconductor device 100 according to at least one embodiment may be applied to an electronic device requiring high performance and low power, such as mobile devices, displays, artificial intelligence (AI) devices, 5G communication equipment, electric devices, Internet of Things (IoT), etc.

In addition, the semiconductor device 100 according to at least one embodiment may include a pair of CFETs in direct contact with both side surfaces of the dielectric wall 115, thereby increasing the scaling effect.

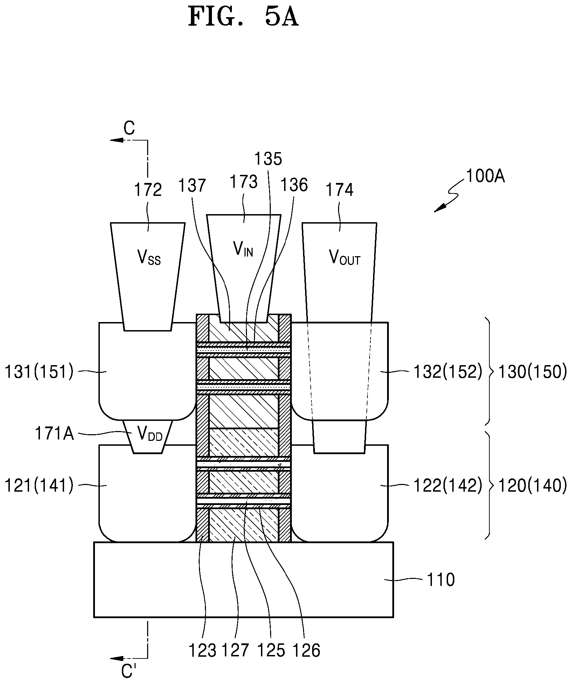

FIG. 5A shows an example of a cross-sectional view taken along line B-B' of the semiconductor device of FIG. 1 in which a position of a first contact 171A is changed compared to FIG. 4.

The first source electrode 121 of the first MOSFET 120 may be connected to the first contact 171A extending from an upper portion of the first MOSFET 120, and the second source electrode 131 of the second MOSFET 130 may be connected to a second contact 172 located on the upper portion of the second MOSFET 130. Both the first contact 171A and the second contact 172 may be located on an upper portion of a semiconductor device 100A.

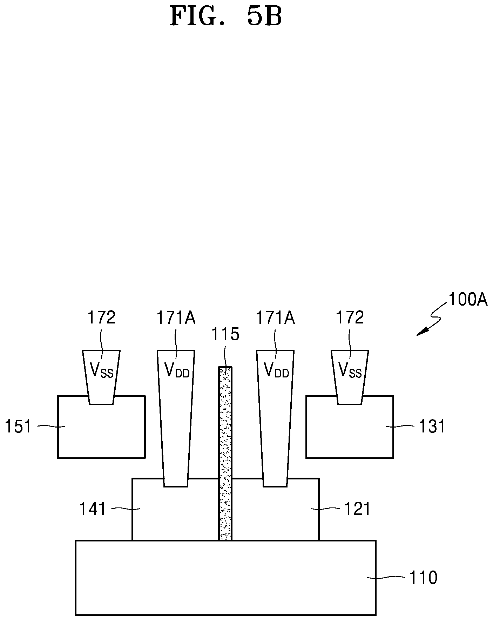

FIG. 5B shows a cross-sectional view taken along line C-C' of the semiconductor device 100A shown in FIG. 5A. For example, the first source electrode 121 may be located relatively close to the dielectric wall 115, and the second source electrode 131 may be located relatively far from the dielectric wall 115. The first contact 171A may be connected to the first source electrode 121 (or the first drain electrode (122) from an upper level of the second source electrode 131 through a space between the dielectric wall 115 and the second source electrode 131. And, the second contact 172 may be connected to the second source electrode 131 from the upper level of the second source electrode 131.

Similarly, the first contact 171A may be connected to the third source electrode 141 (or the third drain electrode 142) from an upper level of the third source electrode 141 through a space between the dielectric wall 115 and the third source electrode 141. And, the second contact 172 may be connected to the fourth source electrode 151 from an upper level of the fourth source electrode 151.

The input contact 173 may be connected to the second gate electrode 137, and the output contact 174 may be connected to the second drain electrode 132 (or the second source electrode 131) and the first drain electrode 122. The input contact 173 and the output contact 174 may be connected from an upper level of the second MOSFET 130.

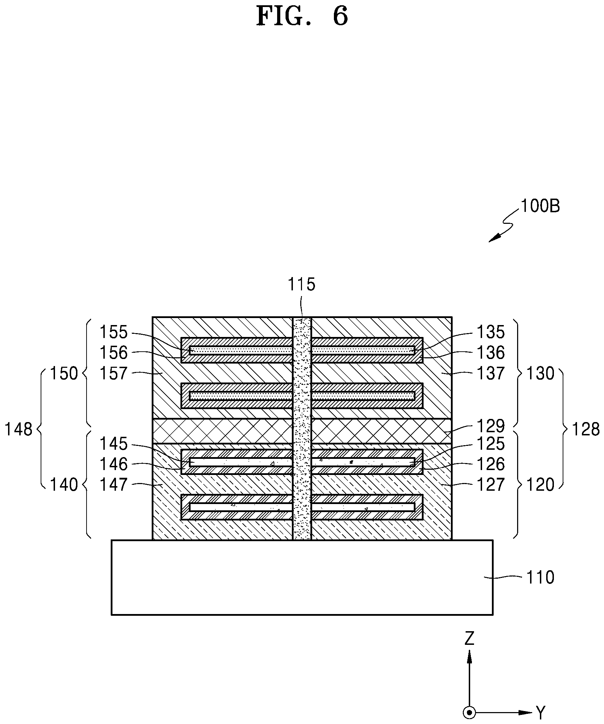

FIG. 6 shows an example in which an isolator 129 is further provided compared to FIG. 3.

In a semiconductor device 100B, the isolators 129 may each be provided between the first MOSFET 120 and the second MOSFET 130 and between the third MOSFET 140 and the fourth MOSFET 150. The isolators 129 may, respectively, electrically separate the first MOSFET 120 from the second MOSFET 130 and the third MOSFET 140 from the fourth MOSFET 150. The isolator 129 may include an insulating material. In this embodiment, the first MOSFET 120, the second MOSFET 130, the third MOSFET 140, and the fourth MOSFET 150 are electrically separated by the dielectric wall 115 and the isolator 129, and thus, current leakage may be prevented from influencing neighboring MOSFETs.

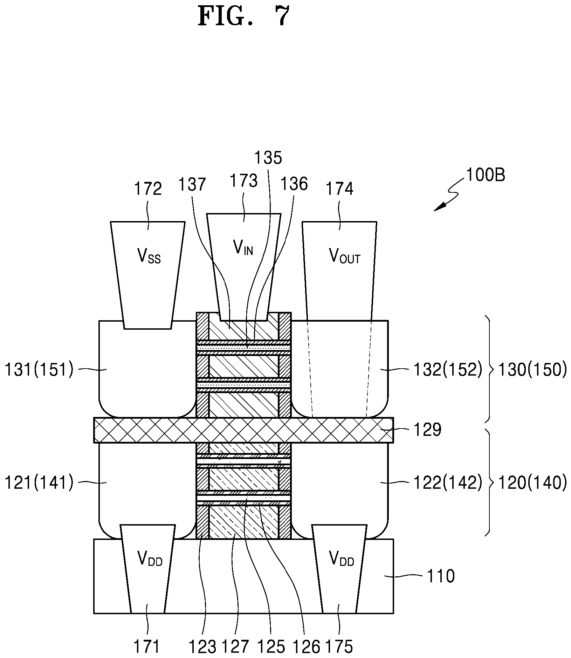

FIG. 7 shows a voltage application structure of the semiconductor device 100B shown in FIG. 6.

The first source electrode 121 (or the first drain electrode 122) of the first MOSFET 120 may be connected to the first contact 171 extending from a lower level of the substrate 110, and the second source electrode 131 of the second MOSFET 130 may be connected to the second contact 172 extending from an upper level of the second MOSFET 130. Also, the first drain electrode 122 of the first MOSFET 120 may be connected to the third contact 175 extending from the lower level of the substrate 110. The first contact 171, the second contact 172, and the third contact 175 may each be connected to a power input line. The input contact 173 may be connected to the second gate electrode 137, and the output contact 174 may be connected to the second drain electrode 132 or the second source electrode 131. The input contact 173 and the output contact 174 may extend from the upper level of the second MOSFET 130.

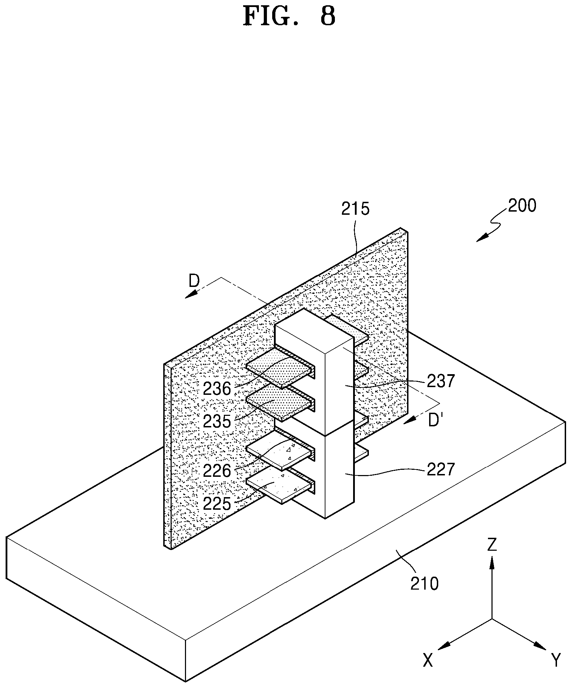

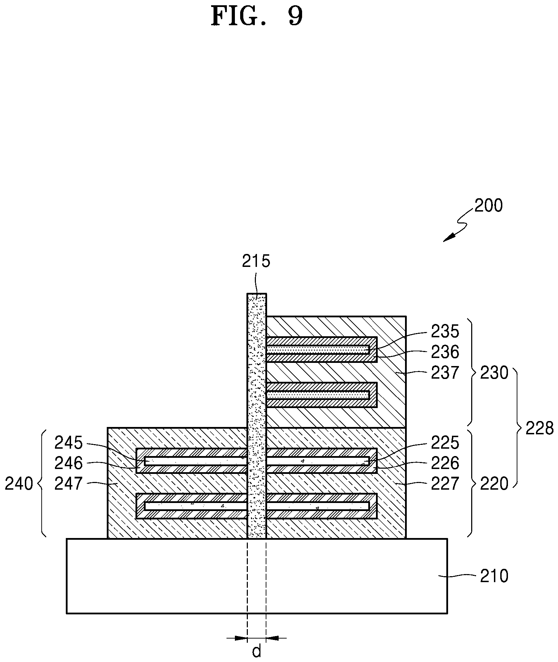

FIG. 8 is a perspective view of a semiconductor device 200 according to at least one embodiment, and FIG. 9 is a cross-sectional view taken along line D-D' of the semiconductor device 200 of FIG. 8.

The semiconductor device 200 may include a dielectric wall 215 provided in the direction (Z direction) perpendicular to the substrate 210, a first MOSFET 220 provided on the substrate 210 in contact with one side surface of the dielectric wall 215, a second MOSFET 230 provided above the first MOSFET 220 in the direction (Z direction) perpendicular to the substrate 210, and a third MOSFET 240 provided on the substrate 210 in contact with the other side surface of the dielectric wall 215.

The first MOSFET 220 and the second MOSFET 230 may configure a CFET 228. The first MOSFET 220 is an n-type or p-type MOSFET, and the second MOSFET 230 may have a different type of conductivity from the first MOSFET 220. For example, when the first MOSFET 220 is an n-type MOSFET, the second MOSFET 230 may be a p-type MOSFET. Alternatively, when the first MOSFET 220 is a p-type MOSFET, the second MOSFET 230 may be an n-type MOSFET.

The third MOSFET 240 may be provided in parallel with the first MOSFET 220 with the dielectric wall 215 disposed therebetween. For example, the third channel sheet 245 of the third MOSFET 240 may be provided in parallel with the first channel sheet 225 of the first MOSFET 220 with the dielectric wall 215 disposed therebetween. The third MOSFET 240 may be a p-type or n-type MOSFET. A distance between the CFET 228 and the third MOSFET 240 may be limited by the thickness d of the dielectric wall 215. By thinning the thickness d of the dielectric wall 215, the scaling of the semiconductor device 200 may be reduced.

The first MOSFET 220 may include one or more first channel sheets 225 arranged in parallel and spaced apart in the direction (Z direction) perpendicular to the substrate 210, a first gate insulating layer 226 surrounding the one or more first channel sheets 225, and a first gate electrode 227 surrounding the first gate insulating layer 226.

The second MOSFET 230 may include one or more second channel sheets 235 arranged in parallel and spaced apart in the direction (Z direction) perpendicular to the substrate 210, a second gate insulating layer 236 surrounding the one or more second channel sheets 235, and a second gate electrode 237 surrounding the second gate insulating layer 236.

The third MOSFET 240 may include one or more third channel sheets 245 arranged in parallel and spaced apart in the direction (Z direction) perpendicular to the substrate 210, a third gate insulating layer 246 surrounding the one or more third channel sheets 245, and a third gate electrode 247 surrounding the third gate insulating layer 246.

The first channel sheet 225, the second channel sheet 235, and the third channel sheet 245 may each include a 2D semiconductor material. The 2D semiconductor material is substantially the same as and/or similar to that described with reference to FIGS. 1 to 4, and thus, a detailed description thereof is omitted here.

The first gate insulating layer 226, the second gate insulating layer 236, and the third gate insulating layer 246 may be provided to respectively surround three side surfaces of the corresponding first channel sheets 225, second channel sheets 235, and third channel sheets 245. Also, one side surface of each of the first gate insulating layer 226, the second gate insulating layer 236, and the third gate insulating layer 246 may be in contact with the dielectric wall 215. The first gate insulating layer 226, the second gate insulating layer 236, and the third gate insulating layer 246 may each have a shape surrounding the corresponding first channel sheets 225, second channel sheets 235, and third channel sheets 245 in a path with one side surface open.

The first gate electrode 227, the second gate electrode 237, and the third gate electrode 247 may be provided to respectively surround the first gate insulating layer 226, the second gate insulating layer 236, and the third gate insulating layer 246.

The semiconductor device 200 may be applied to, for example, a logic and/or memory device.

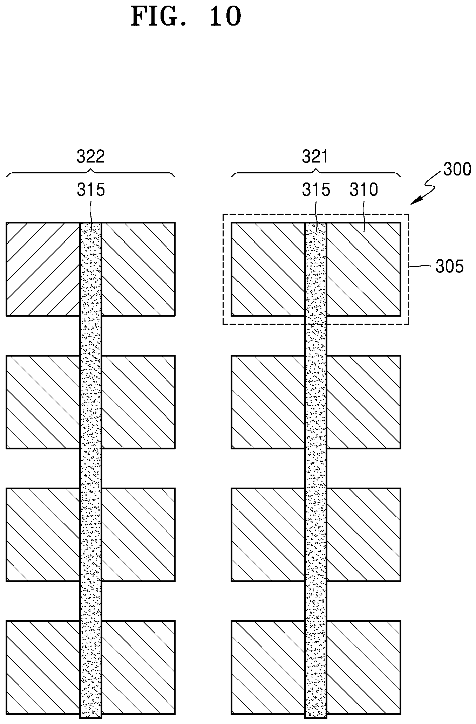

FIG. 10 schematically shows an array structure 300 according to at least one embodiment.

In the array structure 300, a plurality of semiconductor devices 305 are arranged. The semiconductor device 305 may include a dielectric wall 315, one or more MOSFETs 310 provided in contact with one side surface of the dielectric wall 315, and one or more MOSFETs 310 provided in contact with the other side surface of the dielectric wall 315. The one or more MOSFETs 310 may include an n-type MOSFET, a p-type MOSFET, and/or a CFET, as discussed above. For example, the semiconductor device 305 may include at least one of the semiconductor devices described with reference to FIGS. 1 to 9. The semiconductor devices 305 may each include an inverter or a memory device. The semiconductor devices 305 may be stacked and arranged in a vertical or height direction. FIG. 10 shows a structure in which the semiconductor devices 305 are arranged in two rows in the vertical or height direction. The semiconductor devices 305 in a first row 321 and the semiconductor devices 305 in a second row 322 may be arranged at the same height. The dielectric wall 315 may commonly and continuously extend along the semiconductor devices 305 of the same row. The semiconductor devices 305 in the first row 321 and the semiconductor devices 305 in the second row 322 are spaced apart from each other. A separation distance between the semiconductor devices 305 in the first row 321 and the semiconductor devices 305 in the second row 322 may be greater than a thickness of the dielectric wall 315.

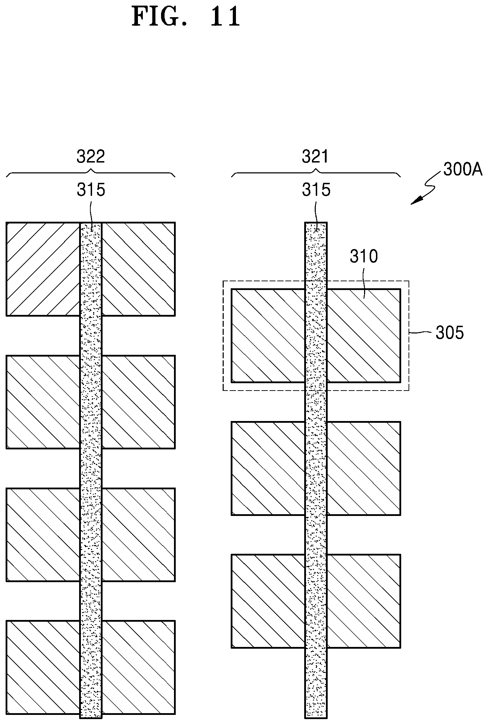

FIG. 11 shows an array structure 300A different from that of FIG. 10.

In the array structure 300A, the semiconductor devices 305 may be arranged in two rows in the vertical direction, and the semiconductor devices 305 in the first row 321 and the semiconductor devices 305 in the second row 322 may be staggered (e.g., alternately arranged at different heights). In the embodiment, the dielectric wall 315 may also commonly and continuously extend along the semiconductor devices 305 in the same row.

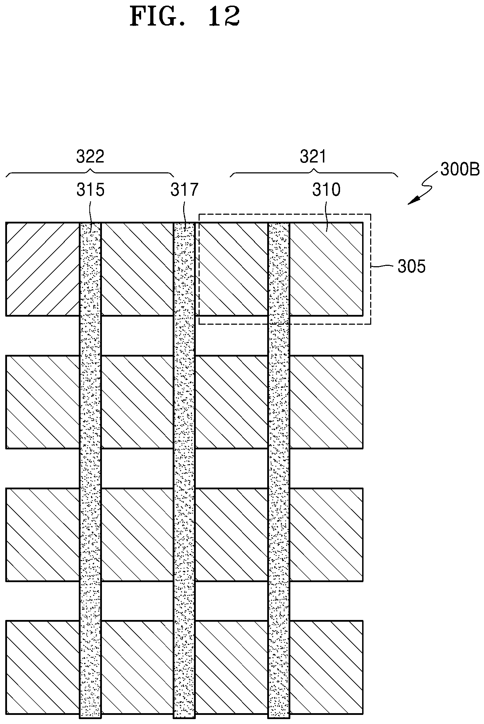

An array structure 300B shown in FIG. 12 may include a dielectric wall 317, the first row 321 arranged in contact with one side surface of the dielectric wall 317, and the second row 322 arranged in contact with the other side surface of the dielectric wall 317. The first row 321 may have a structure in which the semiconductor devices 305 are stacked in the vertical direction, and the second row 322 may have a structure in which the semiconductor devices 305 are stacked in the vertical direction. The dielectric wall 317 may commonly and continuously extend between the first row 321 and the second row 322. FIG. 12 shows an example in which the semiconductor devices 305 in the first row 321 and the second row 322 are arranged at the same height, but the semiconductor devices 305 in the first row 321 and the semiconductor devices 305 in the second row 322 are not limited thereto and may be arranged at different heights.

As described above, in an array structure according to at least one embodiment, semiconductor devices may be vertically stacked in various shapes, and the scaling of the entire array structure may be reduced by using a dielectric wall.

A method of manufacturing a semiconductor device according to at least one embodiment is described below.

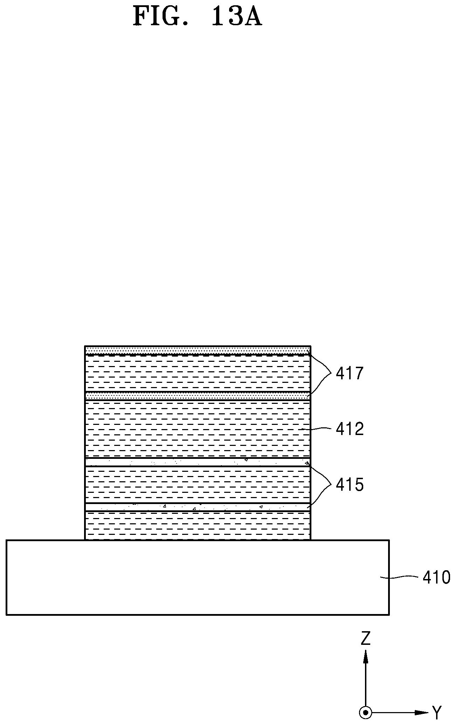

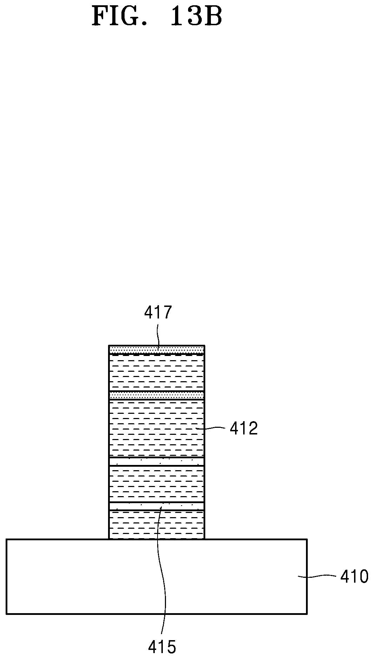

The method of manufacturing the semiconductor device is described through manufacturing process operations with respect to the cross-sectional view taken along lines A-A' and B-B' of FIG. 1, respectively. For example, FIG. 13A is a cross-sectional view taken along line A-A' and FIG. 13B is a cross-sectional view taken along line B-B'.

Referring to FIGS. 13A and 13B, sacrificial layers 412 and first channel sheets 415 are alternately stacked on a substrate 410, and the sacrificial layers 412 and second channel sheets 417 are alternately stacked on an uppermost one of the sacrificial layers 412 alternately stacked with the first channel sheets 415.. The substrate 410 may be the same and/or substantially similar to the substrate 110 (of FIG. 1). For example, the substrate 410 may be an insulating substrate or a semiconductor substrate with an insulating layer formed on its surface; may include, for example, silicon (Si) (such as single crystal silicon, polycrystalline silicon, or amorphous silicon); a group IV semiconductor (such as germanium (Ge)), a group IV-IV compound semiconductor (such as silicon germanium (SiGe) or silicon carbide (SiC)), and/or a group III-V compound semiconductor (such as gallium arsenide (GaAs), indium arsenide (InAs), indium phosphide (InP), etc.). The substrate 410 may be based on a silicon (Si) bulk substrate or a SOI substrate. The substrate 410 is not limited to the bulk or SOI substrate, and may be a substrate based on an epitaxial wafer, a polished wafer, or an annealed wafer.

The sacrificial layer 412 may include materials that may be selectively removed according to an etching gas and/or an etchant. In at least some embodiments, the sacrificial layer 412 may include, for example, an inorganic material (such as SiO₂, Al₂O₃, Si₃N₄, poly-Si, SiGe, etc.), and/or an organic material (such as PMMA, PR, etc.).

The first channel sheet 415 and the second channel sheet 417 may be formed by a chemical vapor deposition (CVD), metal organic chemical vapor deposition (MOCVD), atomic layer deposition (ALD) process, and/or the like. The first channel sheet 415 and the second channel sheet 417 may each include the same (and/or a substantially similar) material as the channel sheets 125 and 135 (see FIG. 3). For example, the first channel sheet 415 and the second channel sheet 417 may each include, for example, a 2D semiconductor material. The 2D semiconductor material may include graphene, black phosphorus, phosphorene, or TMD. The 2D semiconductor material is the same as described above, and thus, a detailed description thereof is omitted here. The 2D semiconductor material may be deposited to a thickness of several nanometers. The first channel sheet 415 and the second channel sheet 417 may be doped with materials having different conductivities. For example, the first channel sheet 415 may be doped with an n-type material, and the second channel sheet 417 may be doped with a p-type material. Alternatively, the first channel sheet 415 may be doped with a p-type material, and the second channel sheet 417 may be doped with an n-type material.

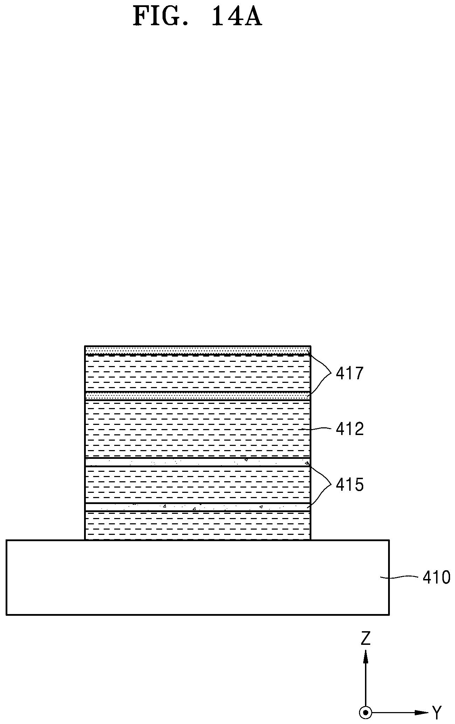

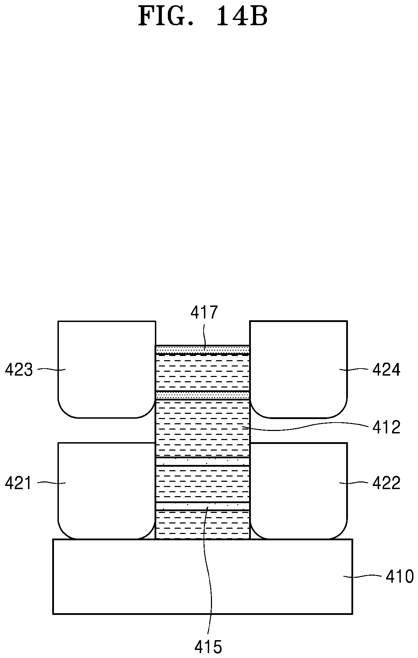

Referring to FIGS. 14A and 14B, a first source electrode 421 and a first drain electrode 422 may be formed to be connected to a first channel sheet 415 by using a mask (not shown). In addition, a second source electrode 423 and a second drain electrode 424 may be formed to be connected to a second channel sheet 417.

The first source electrode 421, the first drain electrode 422, the second source electrode 423, and the second drain electrode 424 may each include a material having electrical conductivity. For example, the first source electrode 421, the first drain electrode 422, the second source electrode 423, and the second drain electrode 424 may each include metal such as magnesium (Mg), aluminum (Al), scandium (Sc), titanium (Ti), vanadium (V), chromium (Cr), manganese (Mn), nickel (Ni), copper (Cu), zinc (Zn), gallium (Ga), zirconium (Zr), niobium (Nb), molybdenum (Mo), lead (Pd), silver (Ag), cadmium (Cd), indium (In), tin (Sn), lanthanum (La), hafnium (Hf), tantalum (Ta), tungsten (W), iridium (Ir), platinum (Pt), gold (Au), or bismuth (Bi), or an alloy thereof. However, the first source electrode 421, the first drain electrode 422, the second source electrode 423, and the second drain electrode 424 are not limited thereto.

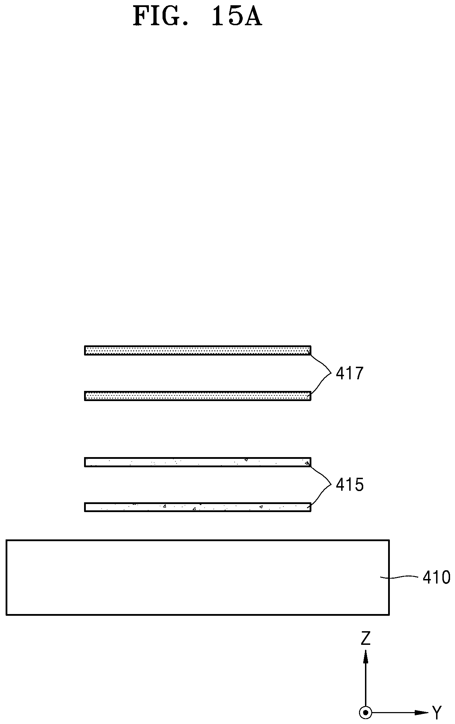

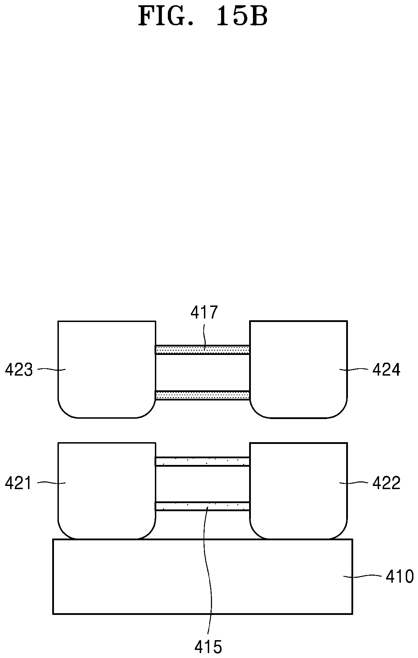

Referring to FIGS. 15A and 15B, the sacrificial layer 412 is removed by using an etching gas that selectively etches only the sacrificial layer 412. At this time, the first channel sheet 415 may be supported by the first source electrode 421 and the first drain electrode 422, and the second channel sheet 417 may be supported by the second source electrode 423 and the second drain electrode 424.

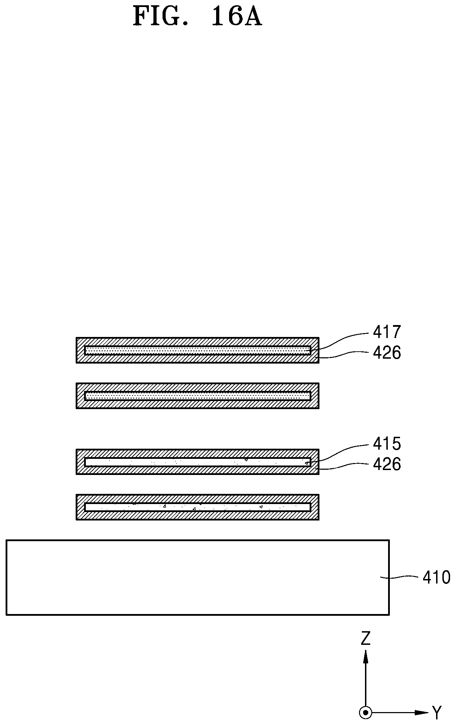

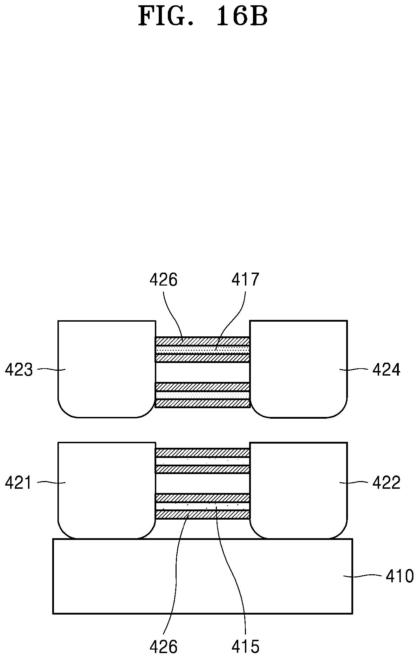

Referring to FIGS. 16A and 16B, a gate insulating layer 426 is deposited on each of the first channel sheet 415 and the second channel sheet 417 The gate insulating layer 426 may be formed by CVD, MOCVD, ALD, and/or the like. The gate insulating layer 426 may be formed to surround four sides of each of the first channel sheet 415 and the second channel sheet 417. The gate insulating layer 426 may include a high-k dielectric material, which is a material with a high dielectric constant. The gate insulating layer 426 may include, for example, aluminum oxide, hafnium oxide, zirconium hafnium oxide, or lanthanum oxide. However, the gate insulating layer 426 is not limited thereto.

In at least one embodiment, the gate insulating layer 426 may include a ferroelectric material. The ferroelectric material may include, for example, an oxide including at least one selected from Hf, Si, Al, Zr, Y, La, Gd, and Sr, but this is an example. In addition, the ferroelectric material may further include a dopant.

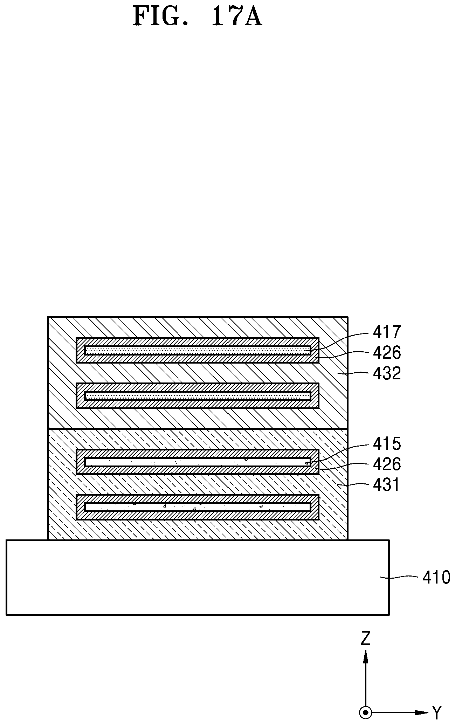

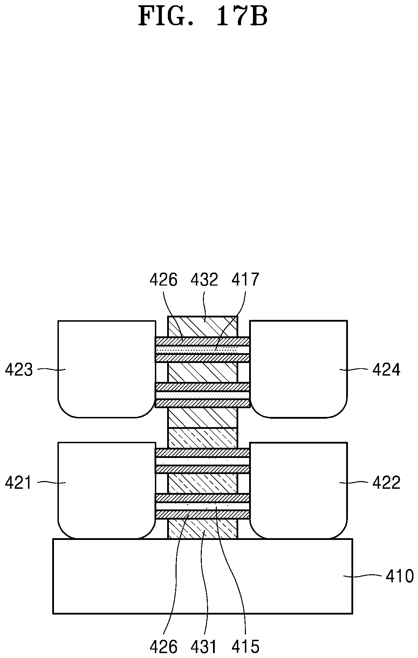

Referring to FIGS. 17A and 17B, a first gate electrode 431 and a second gate electrode 432 are deposited around the gate insulating layer 426. The first gate electrode 431 and the second gate electrode 432 may each include a conductive material, such as a metal material, a conductive nitride, and/or a conductive oxide. Here, the metal material may include, for example, at least one selected from the group consisting of Au, Ti, TiN, TaN, W, Mo, WN, Pt, and Ni. The conductive oxide may include, for example, ITO, IZO, etc. The first gate electrode 431 and the second gate electrode 432 may include the same material or different materials.

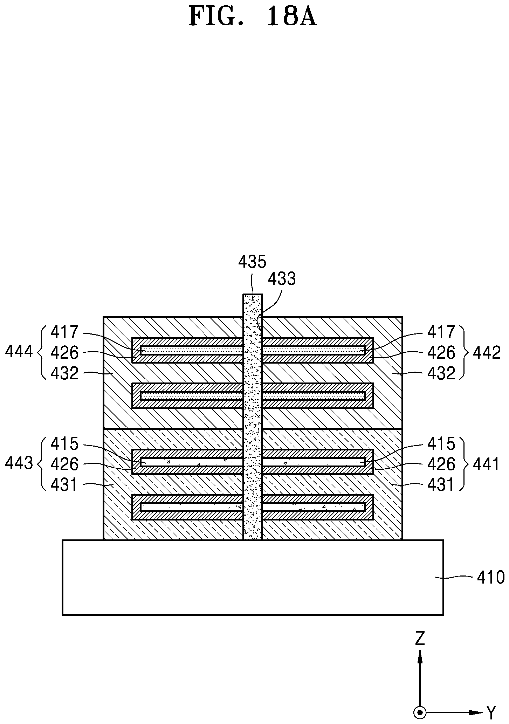

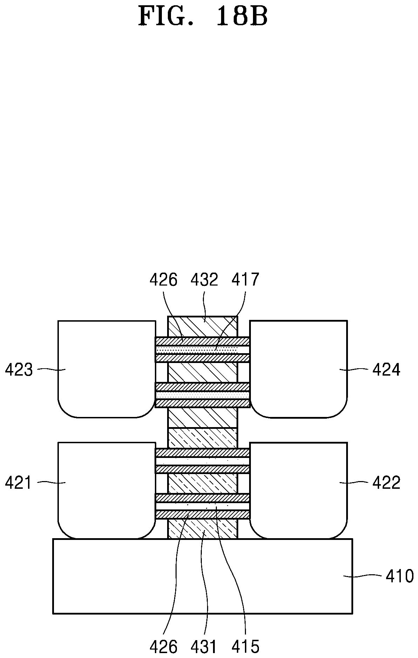

Referring to FIGS. 18A and 18B, a trench 433 is formed by etching from an upper surface of the second gate electrode 432 to the substrate 410. Then, a dielectric is deposited in the trench 433 to form a dielectric wall 435. A pair of first MOSFETs 441, and a second MOSFETs 442, and another pair of third MOSFETs 443 and a fourth MOSFETs 444 which are stacked on both sides of the dielectric wall 435 in a direction perpendicular to the substrate 410 by the dielectric wall 435 may be formed.

In the method of manufacturing the semiconductor device described above, the dielectric wall 435 is formed at a later stage of the manufacturing process after an electrode is formed.

Next, another example of a method of manufacturing the semiconductor device is described. Here, a dielectric wall is formed at an early stage in the manufacturing process before an electrode is formed. Hereinafter, components using the same reference numerals as in the manufacturing method described above have substantially the same materials, functions, and effects, and thus, detailed descriptions thereof are omitted here.

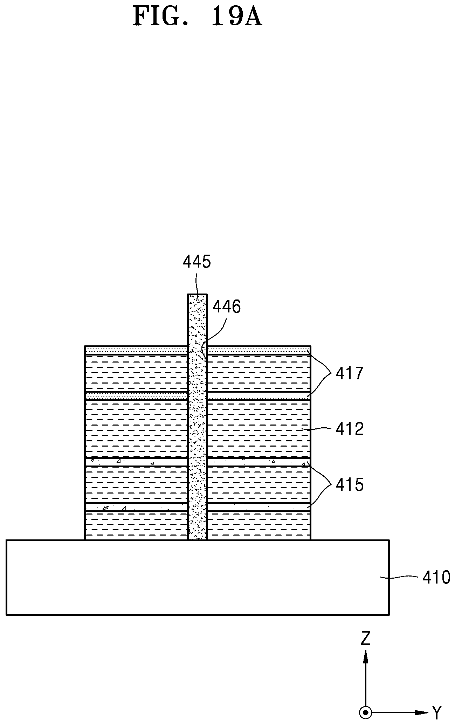

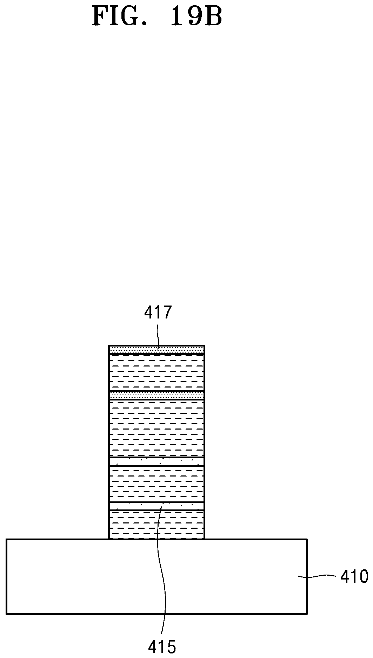

Referring to FIGS. 19A and 19B, the sacrificial layers 412 and the first channel sheets 415 are alternately stacked on the substrate 410, and the sacrificial layers 412 and the second channel sheets 417 are alternately stacked on an uppermost one of the sacrificial layers 412 alternately stacked with the first channel sheets 415. The first channel sheet 415 and the second channel sheet 417 may each include, for example, a 2D semiconductor material. Then, a trench 446 is formed from an upper surface of the second channel sheet 417 to the substrate 410, and a dielectric is deposited on the trench 446 to form a dielectric wall 445. In the embodiment, the dielectric wall 445 is formed at an early stage of the manufacturing process to form two structures on both sides of the dielectric wall 445.

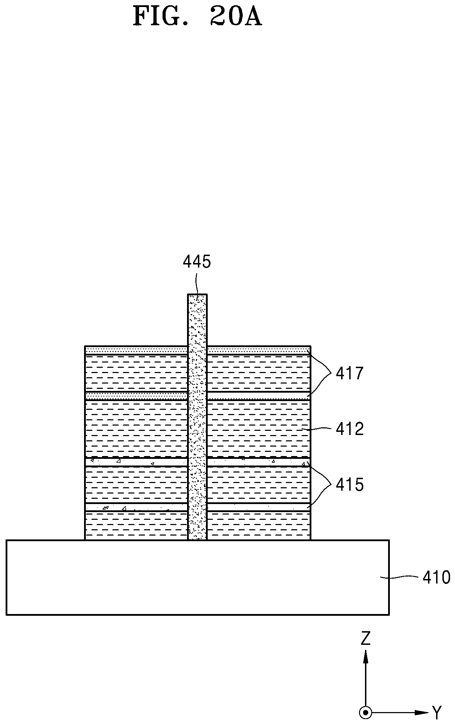

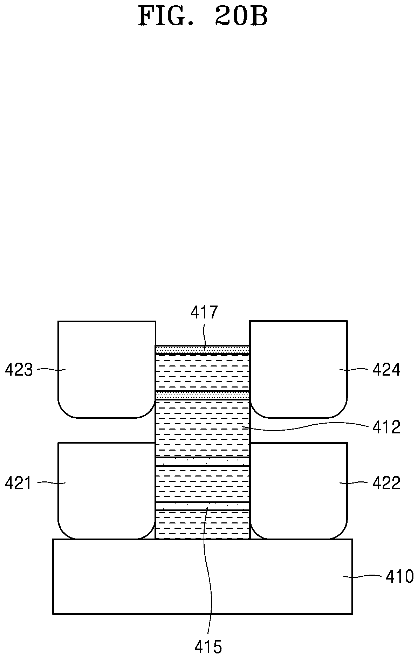

Referring to FIGS. 20A and 20B, the first source electrode 421 and the first drain electrode 422 may be formed to be connected to the first channel sheet 415 by using a mask (not shown). In addition, the second source electrode 423 and the second drain electrode 424 may be formed to be connected to the second channel sheet 417. The first source electrode 421, the first drain electrode 422, the second source electrode 423, and the second drain electrode 424 may each be formed on both sides of the dielectric wall 445. At this stage, there is no change in FIG. 20A.

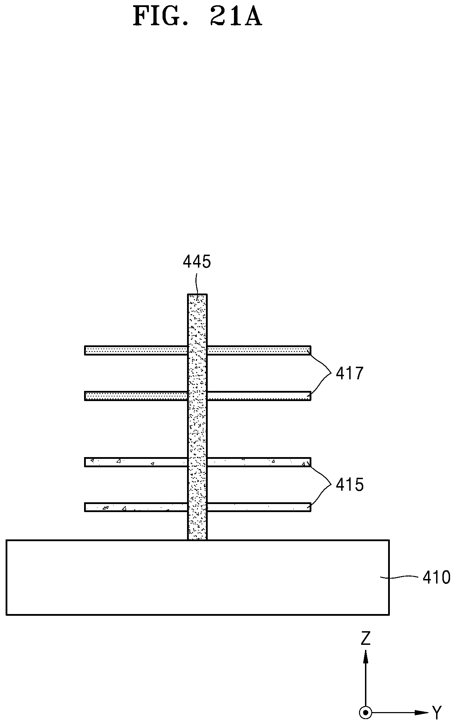

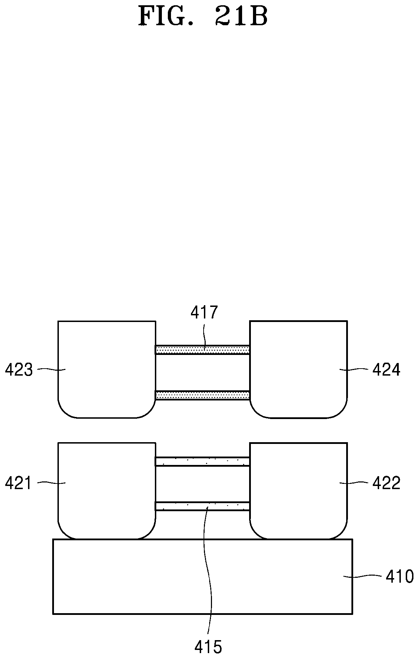

Referring to FIGS. 21A and 21B, the sacrificial layer 412 is removed by using an etching gas that selectively etches only the sacrificial layer 412. At this time, the first channel sheet 415 may be supported by the first source electrode 421 and the first drain electrode 422, and the second channel sheet 417 may be supported by the second source electrode 423 and the second drain electrode 424.

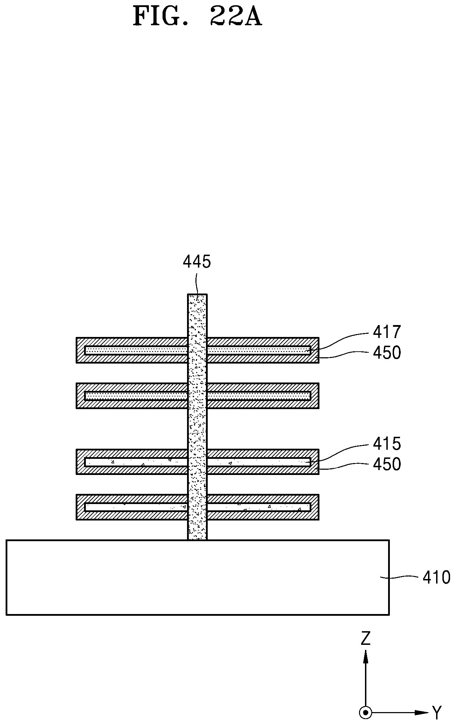

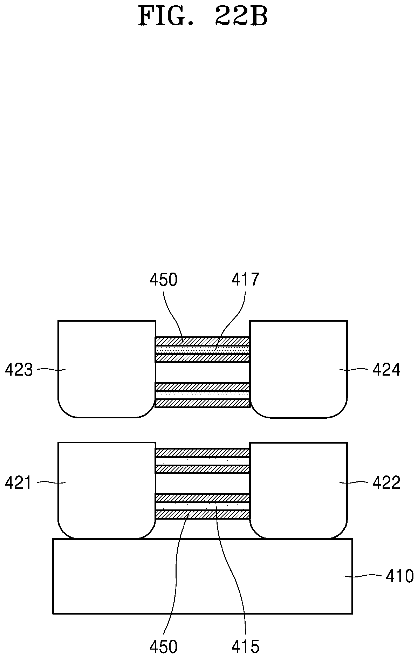

Referring to FIGS. 22A and 22B, a gate insulating layer 450 is deposited on each of the first channel sheet 415 and the second channel sheet 417. The gate insulating layer 450 may be formed by CVD, MOCVD, ALD, and/or the like. The gate insulating layer 450 may be formed to surround three sides of each of the first channel sheet 415 and the second channel sheet 417.

Then, by depositing a gate electrode around the gate insulating layer 450, structures such as those shown in FIGS. 18A may be formed.

As described above, the method of manufacturing the semiconductor device according to at least one embodiment includes two methods of forming a dielectric wall later and forming a dielectric wall first.

The semiconductor device according to at least one embodiment includes a nano-channel sheet in the form of a multi-bridge, thereby suppressing the short channel effect and effectively reducing the channel thickness and channel length. In addition, the semiconductor device according to at least one embodiment has an ultra-small size and excellent electrical performance, and thus it is suitable for application to an IC device with a high degree of integration.

The semiconductor device according to at least one embodiment may form a digital circuit or an analog circuit. In some embodiments, the semiconductor device may be used as a high voltage transistor or a low voltage transistor. For example, the semiconductor device of at least one embodiment may be configured as a high voltage transistor that constitutes a peripheral circuit of a flash memory device or an electrically operable and programmable read only memory (EEPROM) device, which is a nonvolatile memory device that operates at a high voltage. Alternatively, the semiconductor device of at least one embodiment may be configured as a transistor including an IC device for a liquid crystal display (LCD) that requires an operating voltage of 10 V or more, for example, about 20 V to about 30 V, or an IC chip used in a plasma display panel (PDP) that requires an operating voltage of 100 V.

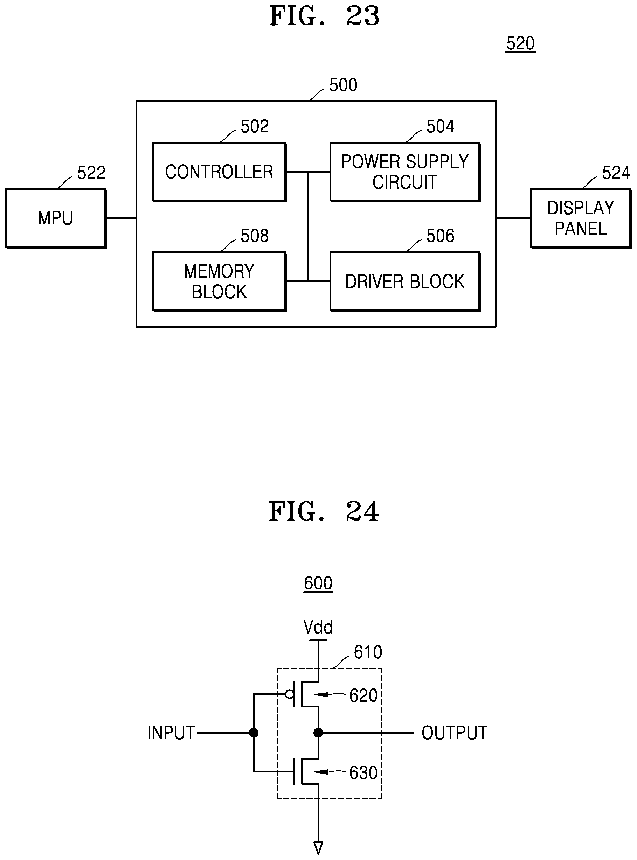

FIG. 23 is a schematic block diagram of a display driver integrated circuit (DDI) 500 and a display device 520 including the DDI 500 according to at least one embodiment.

Referring to FIG. 23, the DDI 500 may include a controller 502, a power supply circuit 504, a driver block 506, and a memory block 508. The controller 502 may receive and decode commands issued from a main processing unit (MPU) 522, and control each block of the DDI 500 to implement operations according to the commands. The power supply circuit 504 generates a driving voltage in response to the control of the controller 502. The driver block 506 drives a display panel 524 by using the driving voltage generated by the power supply circuit 504 in response to the control of the controller 502. The display panel 524 may be a liquid crystal display panel or a plasma display panel. The memory block 508 is a block that temporarily stores commands input to the controller 502 or control signals output from the controller 502, or stores necessary data, and may include memory such as RAM or ROM. The power supply circuit 504 and the driver block 506 may each include the semiconductor devices 100, 100A, 100B, 200, and 305 according to the embodiments described above with reference to FIGS. 1 to 12.

FIG. 24 is a circuit diagram of an inverter 600 according to at least one embodiment.

The inverter 600 includes a complementary metal-oxide semiconductor (CMOS) transistor 610. The CMOS transistor 610 includes a PMOS transistor 620 and an NMOS transistor 630 connected between a power terminal Vdd and a ground terminal. The CMOS transistor 610 may include at least one of the semiconductor devices 100, 100A, 100B, 200, and 305 according to the embodiments described above with reference to FIGS. 1 to 12.

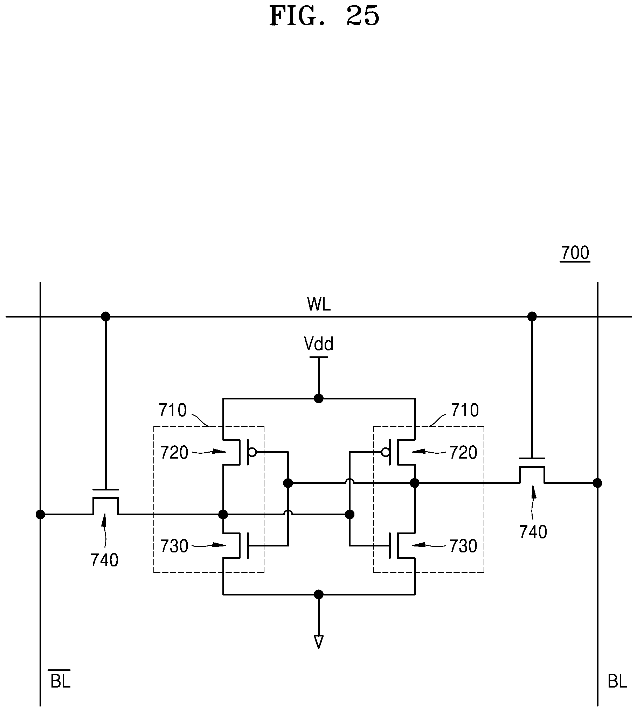

FIG. 25 is a circuit diagram of a SRAM device 700 according to at least one embodiment.

The SRAM device 700 includes a pair of driving transistors 710. The pair of driving transistors 710 each includes a PMOS transistor 720 and an NMOS transistor 730 connected between the power terminal Vdd and a ground terminal. The SRAM device 700 may further include a pair of transfer transistors 740. Sources of the transfer transistors 740 are cross-connected to a common node of the PMOS transistors 720 and the NMOS transistors 730 included in the driving transistors 710. The power terminal Vdd is connected to a source of the PMOS transistor 720, and the ground terminal is connected to a source of the NMOS transistor 730. A word line WL may be connected to a gate of the pair of transfer transistors 740, and a bit line BL and an inverted bit line may be respectively connected to drains of the pair of transfer transistors 740.

At least one of the driving transistors 710 and the transfer transistors 740 of the SRAM device 700 may include the semiconductor devices 100, 100A, 100B, 200, and 305 according to the embodiments described above with reference to FIGS. 1 to 9.

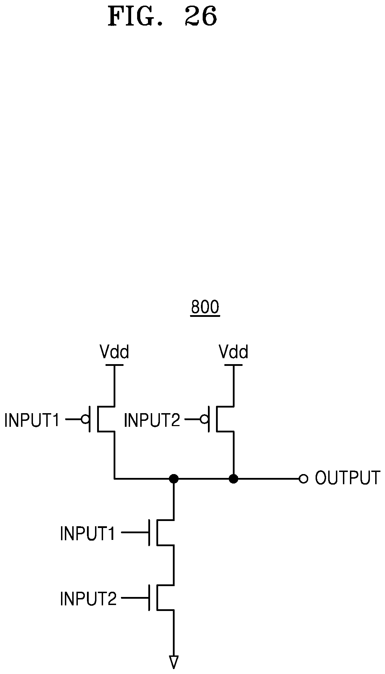

FIG. 26 is a circuit diagram of a NAND circuit 800 according to at least one embodiment.

The NAND circuit 800 includes a pair of CMOS transistors through which different input signals are transmitted. The NAND circuit 800 may include at least one of the semiconductor devices 100, 100A, 100B, 200, and 305 according to the embodiments described above with reference to FIGS. 1 to 9.

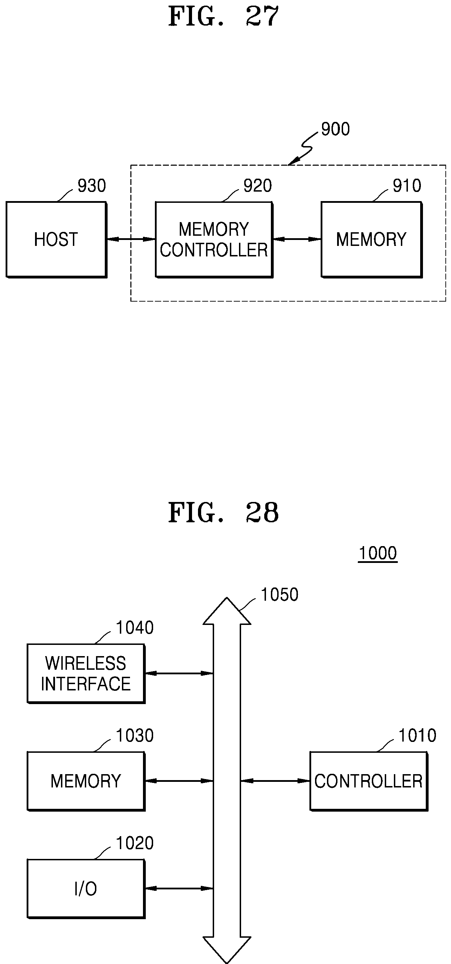

FIG. 27 is a block diagram illustrating an electronic system 900 according to at least one embodiment.

The electronic system 900 includes a memory 910 and a memory controller 920. The memory controller 920 may control the memory 910 to read data from and/or write data to the memory 910 in response to a request from a host 930. At least one of the memory 910 and/or the memory controller 920 may include at least one of the semiconductor devices 100, 100A, 100B, 200, and 305 according to the embodiments described above with reference to FIGS. 1 to 12.

FIG 28 is a block diagram of an electronic system 1000 according to at least one embodiment.

The electronic system 1000 may configure a wireless communication device, or a device capable of transmitting and/or receiving information in a wireless environment. The electronic system 1000 includes a controller 1010, an input/output device (I/O) 1020, a memory 1030, and a wireless interface 1040, which are interconnected via a bus 1050.

The controller 1010 may include at least one of a microprocessor, a digital signal processor, or a processing device similar to these. The input/output device 1020 may include at least one of a keypad, a keyboard, or a display. The memory 1030 may be used to store commands executed by controller 1010. For example, the memory 1030 may be used to store user data. The electronic system 1000 may use the wireless interface 1040 to transmit/receive data over a wireless communication network. The wireless interface 1040 may include an antenna and/or a wireless transceiver. In some embodiments, the electronic system 1000 may be used in a communication interface protocol of a third generation communication system, such as code division multiple access (CDMA), global system for mobile communications (GSM), north American digital cellular (NADC), extended-time division multiple access (E-TDMA), and/or wide band code division multiple access (WCDMA). The electronic system 1000 may include at least one of the semiconductor devices 100, 100A, 100B, 200, and 305 according to the embodiments described above with reference to FIGS. 1 to 9.

The semiconductor device according to at least one embodiment may exhibit good electrical performance with an ultra-small structure, be applied to an IC device, and implement miniaturization, low power, and high performance.

The semiconductor device according to at least one embodiment may arrange a plurality of FETs in contact with a dielectric wall, thereby reducing arrangement distances of the FETs. Therefore, the semiconductor device capable of securing reduced area scaling may be provided.

The semiconductor device array structure according to at least one embodiment may secure reduced area scaling and reduce the size of the overall structure. The embodiment may provide the method of manufacturing the semiconductor device capable of securing reduced area scaling.

The semiconductor device according to at least one embodiment may include a channel including a 2D material, thereby increasing electron mobility, and have a structure in which a gate electrode surrounds a wide surface of the channel, thereby increasing gate controllability.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
a dielectric wall provided in a direction perpendicular to a substrate;
a first metal oxide field effect transistor (MOSFET) on a first side surface of the dielectric wall;
a second MOSFET above the first MOSFET in the direction perpendicular to the substrate; and
a third MOSFET provided in parallel with the first MOSFET on a second side surface of the dielectric wall, the second side surface opposite to the first side surface,
wherein the first MOSFET, the second MOSFET, and the third MOSFET are each in direct contact with the dielectric wall.

2. The semiconductor device of claim 1 or 2, wherein the first MOSFET is an n-type or p-type MOSFET, and the second MOSFET is of a type different from the first MOSFET.

3. The semiconductor device of claim 1, wherein the first MOSFET and the second MOSFET share a gate electrode.

4. The semiconductor device of any preceding claims, wherein
the first MOSFET, the second MOSFET, and the third MOSFET each include one or more channel sheets, a gate insulating layer on each of the one or more channel sheets, and a gate electrode on the gate insulating layer, and
one side surface of each of the one or more channel sheets is in direct contact with the dielectric wall.

5. The semiconductor device of claim 4, wherein the one or more channel sheets include a two-dimensional (2D) semiconductor material.

6. The semiconductor device of claim 5, wherein the 2D semiconductor material includes at least one of graphene, black phosphorus, phosphorene, or transition metal dichalcogenide (TMD).

7. The semiconductor device of any preceding claims, further comprising:
a fourth MOSFET above the third MOSFET in the direction perpendicular to the substrate.

8. The semiconductor device of any preceding claims, further comprising:
an isolator between the first MOSFET and the second MOSFET.

9. The semiconductor device of any preceding claims, wherein the dielectric wall includes at least one of a metal oxide, metal nitride, metal oxynitride, or boron nitride (BN).

10. The semiconductor device of claim 9, wherein the dielectric wall includes at least one of silicon nitride, SiNₓ, silicon oxynitride, SiOₓN_{y}, amorphous boron nitride a-BN, or boron carbon nitride BCN.

11. A semiconductor device array structure comprising:
one or more rows in which a plurality of semiconductor devices according to any preceding claim are arranged in in a direction perpendicular to a substrate,
wherein the dielectric wall commonly and continuously extends along each of the one or more rows.

12. The semiconductor device array structure of claim 11, wherein the one or more rows include
a first row in which the plurality of semiconductor devices are arranged in a line in a first direction; and
a second row in which the plurality of semiconductor devices are arranged in parallel with the first direction and at same height.

13. The semiconductor device array structure of claim 12, further comprising:
a second dielectric wall between the first row and the second row,
wherein the first row and the second row are in contact with the second dielectric wall.

14. The semiconductor device array structure of claim 11, wherein the one or more rows include
a first row in which the plurality of semiconductor devices are arranged in a line in a first direction; and
a second row in which the plurality of semiconductor devices are arranged in parallel with the first direction and alternate at different heights.

15. A method of manufacturing a semiconductor device, the method comprising:
alternately stacking first sacrificial layers and first channel sheets on a substrate;
alternately stacking second sacrificial layers and second channel sheets on the first sacrificial layers;
forming a first source electrode and a first drain electrode such that the first source electrode and the first drain electrode are connected to the first channel sheets;
forming a second source electrode and a second drain electrode such that the second source electrode and the second drain electrode are connected to the second channel sheet;
removing the first and second sacrificial layers;
forming gate insulating layers such that a gate insulating layer is on each of the first channel sheets and the second channel sheets;
forming a first gate electrode and a second gate electrode around the gate insulating layers;
forming a trench in the first and second gate electrodes by etching from an upper surface of the second gate electrode to the substrate; and
forming a dielectric wall by depositing a dielectric material in the trench.
